# EUROPEAN PATENT APPLICATION

(11) **EP 4 810 971 A1**
(43) Date of publication of application: **23.09.2026**
(21) Application number: 24891534.0
(22) Date of filing: 18.11.2024
(51) Int. Cl.: G01R 31/34, G01R 31/00, H02P 29/02

(54) **DETERIORATION INFORMATION SYSTEM AND PROGRAM**

(30) Priority: 17.11.2023 JP 2023196083
(71) Applicant: Daikin Industries, Ltd., Osaka-shi, Osaka 530-0001 (JP)
(72) Inventor: KOBORI, Hirokazu, Osaka 530-0001 (JP); ARAKI, Takeshi, Osaka 530-0001 (JP); OGAWA, Takuro, Osaka 530-0001 (JP)
(74) Representative: Global IP Europe Patentanwaltskanzlei
(86) International application number: PCT/JP2024/040858
(87) International publication number: WO 2025/105499

(57) **Abstract**

A deterioration information system 1 is a deterioration information system 1 that calculates information correlated with deterioration of a compressor 2, and includes a control unit. The control unit has a calculation function of calculating a feature amount correlated with deterioration of the compressor 2 from waveform data acquired from the compressor 2, and a selection function of outputting a feature amount when an operation condition of the compressor 2 at the time when the waveform data is acquired falls within a predetermined range.

## Description

### TECHNICAL FIELD

A deterioration information system and a program.

### BACKGROUND ART

PTL 1 (Japanese Unexamined Patent Application Publication No. 2022-101344) discloses an electric power conversion device having a configuration that is simpler but is capable of performing diagnosis related to a deterioration abnormality in an alternating current electric motor.

### SUMMARY OF INVENTION

### <Technical Problem>

However, in diagnosis based on a result of monitoring, which is disclosed in PTL 1, high diagnosis accuracy may not be acquired.

The present disclosure proposes a deterioration information system and a program that output a suitable feature amount correlated with deterioration.

### <Solution to Problem>

A deterioration information system according to a first aspect is a deterioration information system that calculates information correlated with deterioration of a compressor, and includes a control unit. The control unit has a calculation function of calculating a feature amount correlated with deterioration of the compressor from waveform data acquired from the compressor, and a selection function of outputting a feature amount when an operation condition of the compressor at the time when the waveform data is acquired falls within a predetermined range.

The control unit in the deterioration information system has the calculation function of calculating a feature amount correlated with deterioration of the compressor, and the selection function of outputting a feature amount when an operation condition of the compressor falls within a predetermined range. Therefore, the deterioration information system is capable of outputting a suitable feature amount for diagnosing deterioration.

A deterioration information system according to a second aspect is the deterioration information system according to the first aspect, further including a storage device that stores a plurality of the feature amounts of a plurality of the compressors.

A deterioration information system according to a third aspect is the deterioration information system according to the second aspect, in which the storage device is a server or a cloud. Each of the feature amounts stored in the storage device is a feature amount selected based on the operation condition of each of the compressors at the time when the waveform data used for the calculation is acquired.

A deterioration information system according to a fourth aspect is the deterioration information system according to any aspect of the first aspect to the third aspect, in which the waveform data is electric current waveform data indicating a waveform of an electric current in a motor that the compressor includes. The feature amount indicates a magnitude of a frequency component, the magnitude being N times or N/M times of a number of rotations of the motor. N and M are integers. M is greater than N.

A deterioration information system according to a fifth aspect is the deterioration information system according to any aspect of the first aspect to the fourth aspect, in which the compressor includes a motor driven by a motor drive device. The motor drive device includes a direct current generation unit and a conversion unit. The direct current generation unit generates a voltage of a direct current in accordance with a power source voltage supplied from an external power source. The conversion unit converts the voltage of the direct current, the voltage being generated by the direct current generation unit, into a voltage of an alternating current through a switching operation and supplies the voltage of the alternating current to the motor. The operation condition is at least one of a number of rotations of the motor that the compressor includes, pressure of a refrigerant discharged from the compressor, pressure of the refrigerant sucked into the compressor, a temperature of the refrigerant discharged from the compressor, a temperature of the refrigerant sucked into the compressor, a frequency component of a number of rotations of torque of the compressor, and the voltage of the direct current. The predetermined range is a range of the operation condition when an operation state of the compressor is a steady state.

A deterioration information system according to a sixth aspect is the deterioration information system according to any aspect of the first aspect to the fifth aspect, in which the operation condition is at least one of a number of rotations of a motor that the compressor includes, pressure of a refrigerant discharged from the compressor, pressure of the refrigerant sucked into the compressor, a temperature of the refrigerant discharged from the compressor, and a temperature of the refrigerant sucked into the compressor. The predetermined range is a range of the operation condition that is set in advance.

A deterioration information system according to a seventh aspect is the deterioration information system according to any aspect of the first aspect to the sixth aspect, in which the predetermined range is changeable from outside.

A program according to an eighth aspect is a program causing a computer in a control device that calculates information correlated with deterioration of a compressor to execute a calculation function and a selection function. The calculation function is a function of calculating a feature amount correlated with deterioration of the compressor from waveform data acquired from the compressor. The selection function is a function of outputting a feature amount when an operation condition of the compressor at the time when the waveform data is acquired falls within a predetermined range.

A program according to a ninth aspect is the program according to the eighth aspect for further causing a storing function of storing a plurality of the feature amount of a plurality of the compressors in the storage device to be executed.

A program according to a tenth aspect is the program according to the ninth aspect, in which the storage device is a server or a cloud. Each of the feature amounts stored in the storage device is a feature amount selected based on the operation condition of each of the compressors at the time when the waveform data used for the calculation is acquired.

A program according to an eleventh aspect is the program according to any aspect of the eighth aspect to the tenth aspect, in which the waveform data is electric current waveform data indicating a waveform of an electric current in a motor that the compressor includes. The feature amount indicates a magnitude of a frequency component, the magnitude being N times or N/M times of a number of rotations of the motor. N and M are integers. M is greater than N.

A program according to a twelfth aspect is the program according to any aspect of the eighth aspect to the eleventh aspect, in which the compressor includes a motor driven by a motor drive device. The motor drive device includes a direct current generation unit and a conversion unit. The direct current generation unit generates a voltage of a direct current in accordance with a power source voltage supplied from an external power source. The conversion unit converts the voltage of the direct current, the voltage being generated by the direct current generation unit, into a voltage of an alternating current through a switching operation and supplies the voltage of the alternating current to the motor. The operation condition is at least one of a number of rotations of the motor that the compressor includes, pressure of a refrigerant discharged from the compressor, pressure of the refrigerant sucked into the compressor, a temperature of the refrigerant discharged from the compressor, a temperature of the refrigerant sucked into the compressor, a frequency component of a number of rotations of torque of the compressor, and the voltage of the direct current. The predetermined range is a range of the operation condition when an operation state of the compressor is a steady state.

A program according to a thirteenth aspect is the program according to any aspect of the eighth aspect to the twelfth aspect, in which the operation condition is at least one of a number of rotations of a motor that the compressor includes, pressure of a refrigerant discharged from the compressor, pressure of the refrigerant sucked into the compressor, a temperature of the refrigerant discharged from the compressor, and a temperature of the refrigerant sucked into the compressor. The predetermined range is a range of the operation condition that is set in advance.

A program according to a fourteenth aspect is the program according to any aspect of the eighth aspect to the thirteenth aspect, in which the predetermined range is changeable from outside.

A deterioration information system according to a fifteenth aspect is the deterioration information system according to any aspect of the first aspect to the seventh aspect, in which the selection function includes a first selection function and a second selection function. The first selection mechanism is a function of selecting waveform data when the operation condition of the compressor falls within a predetermined range. The second selection function is a function of selecting the feature amount when the operation condition of the compressor is closest to an operation condition that is set in advance, from among a plurality of the feature amounts calculated by the calculation function from the waveform data selected by the first selection function.

### BRIEF DESCRIPTION OF DRAWINGS

[Fig. 1] Fig. 1 is a schematic configuration diagram illustrating a deterioration information system 1.
[Fig. 2] Fig. 2 is a configuration diagram of a compressor 2.
[Fig. 3] Fig. 3 is a configuration diagram of a control device 11.
[Fig. 4] Fig. 4 is a graph when oil shortage has occurred.
[Fig. 5] Fig. 5 is a graph when liquid compression has occurred.
[Fig. 6] Fig. 6 is a graph when insulation deterioration has occurred.
[Fig. 7] Fig. 7 is a graph illustrating V0 when wearing has occurred.
[Fig. 8] Fig. 8 is a graph illustrating VF when wearing has occurred.
[Fig. 9] Fig. 9 is a graph illustrating Vfr when wearing has occurred.
[Fig. 10] Fig. 10 is a configuration diagram of a terminal 13.
[Fig. 11] Fig. 11 is a flowchart illustrating operation of the deterioration information system 1.
[Fig. 12] Fig. 12 is a configuration diagram of the control device 11.
[Fig. 13] Fig. 13 is a flowchart illustrating operation of the deterioration information system 1.
[Fig. 14] Fig. 14 is a configuration diagram of the control device 11.
[Fig. 15] Fig. 15 is a configuration diagram of the terminal 13.
[Fig. 16] Fig. 16 is a flowchart illustrating operation of the deterioration information system 1.
[Fig. 17] Fig. 17 is a configuration diagram of the terminal 13.
[Fig. 18] Fig. 18 is a schematic configuration diagram illustrating a deterioration information system 3.
[Fig. 19] Fig. 19 is a configuration diagram of a control device 31.
[Fig. 20] Fig. 20 is a flowchart illustrating operation of the deterioration information system 3.
[Fig. 21] Fig. 21 is a configuration diagram of the control device 31.
[Fig. 22] Fig. 22 is a flowchart illustrating operation of the deterioration information system 3.
[Fig. 23] Fig. 23 is a schematic configuration diagram illustrating a deterioration information system 4.
[Fig. 24] Fig. 24 is a configuration diagram of a control device 41.
[Fig. 25] Fig. 25 is a flowchart illustrating operation of the deterioration information system 4.

### DESCRIPTION OF EMBODIMENTS

### <First Embodiment>

A deterioration information system 1 according to a first embodiment will now be described herein. The deterioration information system 1 is a system that calculates information correlated with deterioration of a compressor 2.

### (1) Overall Configuration

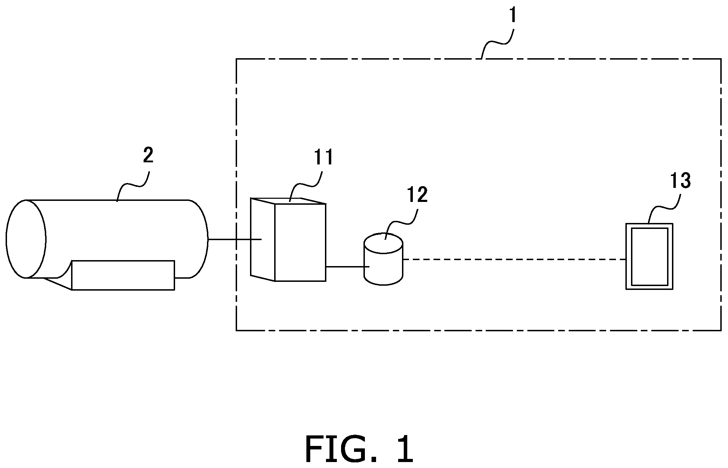

An overall configuration of the deterioration information system 1 will now be described herein. Fig. 1 is a schematic configuration diagram illustrating the deterioration information system 1. The deterioration information system 1 includes a control device 11, a storage device 12, and a terminal 13. Note that a number of the control devices 11 that the deterioration information system 1 include may be plural. Note that a number of the storage devices 12 that the deterioration information system 1 include may be plural. Note that a number of the terminals 13 that the deterioration information system 1 include may be plural. In the present embodiment, the control device 11 and the terminal 13 configure a control unit.

### (1-1) Control Device 11

The control device 11 is coupled to the compressor 2 and the storage device 12 in a wired or wireless manner. A detailed configuration of the control device 11 will be described later.

### (1-2) Storage Device 12

The storage device 12 stores a feature amount correlated with deterioration of the compressor 2 and others. Details of the feature amount will be described later. The storage device 12 may be used as a database. Examples of the storage device 12 include a hard disk drive (HDD), a solid-state disk (SSD), an electrically erasable programmable read-only memory (EEPROM), and a flash memory. The storage device 12 is coupled to the control device 11 in a wired or wireless manner. The storage device 12 is coupled to the terminal 13 in a wired or wireless manner through an operation of a user of the terminal 13.

### (1-3) Terminal 13

The terminal 13 is a tablet terminal. The terminal 13 may be any one of a laptop personal computer, a smartphone, and a desktop personal computer. The terminal 13 is coupled to the storage device 12 in a wired or wireless manner through an operation of the user of the terminal 13. An example of the user of the terminal 13 is a service engineer. A detailed configuration of the terminal 13 will be described later.

### (1-4) Compressor 2

The compressor 2 is provided in a refrigeration cycle device (not illustrated). The refrigeration cycle device is a device that utilizes a vapor compression refrigeration cycle to perform air conditioning in a target space for air conditioning. Examples of the air conditioning include cooling, freezing, heating, humidification, dehumidification, air purification, air blowing, and ventilation.

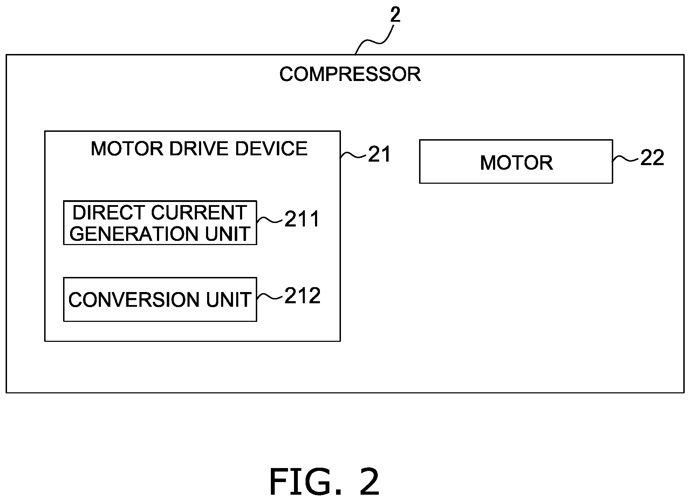

Fig. 2 is a configuration diagram of the compressor 2. The compressor 2 mainly includes a motor drive device 21 and a motor 22 driven by the motor drive device 21. The motor drive device 21 mainly includes a direct current generation unit 211 and a conversion unit 212.

### (1-4-1) Direct Current Generation Unit 211

The direct current generation unit 211 generates a voltage of a direct current in accordance with a power source voltage supplied from an external power source. For example, a diode bridge circuit in which a plurality of rectifier diodes are coupled in a bridge shape and a direct current unit that includes a capacitor and smooths an output of the diode bridge circuit are included and configured.

### (1-4-2) Conversion Unit 212

The conversion unit 212 converts the voltage of the direct current, which is generated by the direct current generation unit 211, into a voltage of an alternating current through a switching operation and supplies the voltage of the alternating current to the motor 22. A rotational speed of the compressor 2 changes in response to a frequency of the voltage of the alternating current, which the conversion unit 212 outputs. The conversion unit 212 performs control to allow the rotational speed of the compressor 2 to reach a command value through a switching operation.

### (1-5) Hardware Configuration

The control device 11 and the terminal 13 are achieved by using a computer. The control device 11 and the terminal 13 each include a control computation device and a storage device. As the control computation device, it is possible to use a processor such as a central processing unit (CPU) or a graphics processing unit (GPU). The control computation device reads a program stored in the storage device and performs predetermined image processing and computation processing in accordance with the program. Furthermore, the control computation device is capable of writing a result of computation in the storage device and of reading information stored in the storage device in accordance with the program.

### (2) Detailed Configuration

### (2-1) Control Device 11

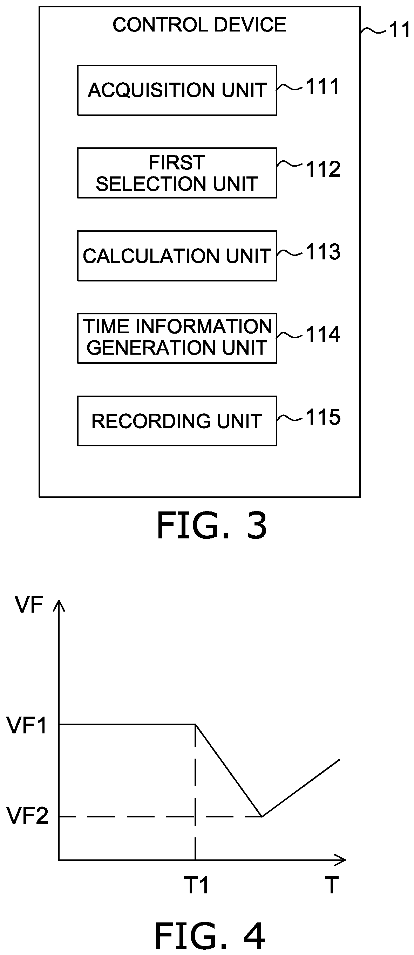

The detailed configuration of the control device 11 will now be described herein. Fig. 3 is a configuration diagram of the control device 11. Fig. 3 illustrates various functions achieved by the control computation device. The control device 11 includes an acquisition unit 111, a first selection unit 112, a calculation unit 113, a time information generation unit 114, and a recording unit 115.

### (2-1-1) Acquisition Unit 111

The acquisition unit 111 acquires an operation condition and waveform data based on information acquired from various sensors provided in the compressor 2 and the refrigeration cycle device. The operation condition is at least one of a number of rotations of the motor 22, pressure of a refrigerant discharged from the compressor 2, pressure of the refrigerant sucked into the compressor 2, a temperature of the refrigerant discharged from the compressor 2, a temperature of the refrigerant sucked into the compressor 2, a frequency component of a number of rotations of torque of the compressor 2, and the voltage of the direct current generated by the direct current generation unit 211. Among the compressors 2, there is a compressor provided with two ports that are a suction port serving as a port for sucking the refrigerant and an injection port. In this case, the pressure of the refrigerant sucked into the compressor 2 refers to one or both of the pressure at the suction port and the pressure at the injection port. The temperature of the refrigerant sucked into the compressor 2 refers to one or both of the temperature at the suction port and the temperature at the injection port.

The waveform data is electric current waveform data indicating a waveform of an electric current in the motor 22. The electric current waveform data is acquired from current sensors attached to three winding wires of the motor. Alternatively, the electric current waveform data may be derived from a direct current detected by a shunt resistance provided in the direct current unit and a switching pattern. The waveform data may be either sound waveform data indicating a waveform of sound of the compressor 2 or vibration waveform data indicating a waveform of vibration of the compressor 2. An example of the sound of the compressor 2 is sound acquired from a microphone provided near the compressor 2. Examples of the vibration of the compressor 2 include vibration acquired from a vibration sensor on a housing of the compressor 2, vibration acquired from a vibration sensor on a suction tube of the compressor 2, and vibration acquired from a vibration sensor on a discharge tube of the compressor 2.

The acquisition unit 111 acquires an operation condition and waveform data from the compressor 2 per time interval that is set in advance. For example, the acquisition unit 111 acquires an operation condition and waveform data from the compressor 2 per second.

### (2-1-2) First Selection Unit 112

The first selection unit 112 selects waveform data when the operation condition of the compressor 2 at the time when the waveform data is acquired falls within a predetermined range. The term "time when waveform data is acquired" indicates time of day when the acquisition unit 111 has acquired waveform data. Alternatively, the term "time when waveform data is acquired" may be a time zone in which the acquisition unit 111 has acquired waveform data.

Examples of the "operation condition of the compressor 2 at the time when waveform data is acquired" include an average value of an operation condition in a predetermined period and an operation condition at predetermined time of day. Examples of the predetermined period described above include a time zone in which the acquisition unit 111 has acquired waveform data. Examples of the predetermined time of day described above include specific time of day in a time zone in which the acquisition unit 111 has acquired waveform data or time of day at which the acquisition unit 111 has acquired waveform data.

When waveform data selected by the first selection unit 112 is data including time, examples of the time include time identical to time including "time when waveform data is acquired" and time different from time including "time when waveform data is acquired". When waveform data selected by the first selection unit 112 is data including time of day, examples of the time of day include time of day identical to "time when waveform data is acquired" and time of day different from "time when waveform data is acquired".

Note that, in calculation of a feature amount using sequential estimation such as Kalman filter, a present feature amount is acquired from a feature amount acquired previously and waveform data in a predetermined period A. In this case, the present feature amount is further influenced by waveform data in a period before the predetermined period A, an influence of waveform data in a period close to the predetermined period A is larger, and an influence of waveform data in a period far from the predetermined period A is relatively small. As described above, in calculation of a feature amount using sequential estimation, it is assumed that time when waveform data is acquired is a time zone from predetermined time before the time of day of calculating a feature amount to the time of day of calculating the feature amount. For example, the predetermined time is five minutes.

A state in which "the operation condition of the compressor 2 falls within a predetermined range" indicates that the operation condition is in a steady state. Alternatively, the state in which "the operation condition of the compressor 2 falls within a predetermined range" indicates that the operation condition falls within a range for the operation condition, which is set in advance. The predetermined range indicates a range in which an operation state of the compressor 2 is in a steady state or a range for the operation condition, which is set in advance.

The predetermined range is written in an EEPROM or a flash memory and is changeable from outside. For example, the service engineer or a manager rewrites the predetermined range when maintenance is performed on site or in a remote manner. The predetermined range may be changed based on operation conditions accumulated through operations for one or a plurality of users in a certain period. For example, the predetermined range may be changed based on an operation condition with an occurrence rate that is equal to or greater than a certain rate among operation conditions accumulated through operations for one or a plurality of users in a certain period. For example, when the number of rotations is divided by an increment of five rotations per second (rps), a range of the number of rotations with a highest occurrence rate is acquired. The predetermined range is changed to the acquired range of the number of rotations. By performing a change in this way, it is possible to avoid a risk that an operation condition does not fall within a predetermined range, which makes it difficult to acquire waveform data for calculating a feature amount.

A setting example of a "range of an operation condition that is set in advance" will now be described herein. It is assumed that the feature amount be a frequency component of an electric current correlated with a magnitude of torque pulsation generated in a compression stage in the compressor 2. In this case, a "range of an operation condition that is set in advance" is set to a range of a low number of rotations. Specifically, a "range of an operation condition that is set in advance" is set to a range of a number of rotations of 50% or less of a maximum number of rotations of the compressor 2. One reason for this setting is that, when wearing of a member configuring a compression mechanism of the compressor 2 is significant, a frequency component that is N times of a number of rotations of torque of the compressor 2 changes, and a frequency component that is high in characteristic of transmission from the torque to the electric current of the compressor 2 is attenuated, due to an influence of inertia. By setting the "range of the operation condition that is set in advance" to the range of the number of rotations of 50% or less of the maximum number of rotations of the compressor 2, it is possible to focus on a frequency component that is low in attenuation, and, since a feature amount changes significantly when wearing has occurred, it is possible to set the feature amount suitable for observing a state of wearing.

The steady state of the compressor 2 will now be described herein in detail.

### (2-1-2-1) Steady State in Number of Rotations of Motor 22

The number of rotations of the motor is detected by a sensor or estimated in a sensor-less manner. The steady state in the number of rotations of the motor 22 is, for example, a state in which a difference between a command value of the number of rotations and an actual measurement value of the number of rotations falls within a predetermined difference. For example, the predetermined difference is 0.1 rps. The steady state in the number of rotations of the motor 22 may be a state in which a difference between a present value and a previous value of actual measurement values of the numbers of rotations falls within a predetermined difference. For example, the previous value is an actual measurement value of the number of rotations acquired one second before the present value, and the predetermined difference is 0.1 rps.

Note that, instead of an actual measurement value of the number of rotations, a command value of the number of rotations may be used. For example, the steady state in the number of rotations of the motor 22 may be a state in which a difference between a present value and a previous value of command values of the numbers of rotations falls within a predetermined difference.

Alternatively, the steady state in the number of rotations of the motor 22 may be a state in which neither an acceleration flag nor a deceleration flag pertaining to the number of rotations, which is held in the control device 11, is set. The control device 11 may set the acceleration flag pertaining to the number of rotations, which is held in the control device 11, when the number of rotations of the motor 22 is to be increased, and may unset the acceleration flag when the number of rotations of the motor 22 is not to be increased. In addition, the control device 11 may set the deceleration flag pertaining to the number of rotations, which is held in the control device 11, when the number of rotations of the motor 22 is to be decreased, and may unset the deceleration flag when the number of rotations of the motor 22 is not to be decreased.

### (2-1-2-2) Steady State in Pressure of Refrigerant discharged from Compressor 2

The pressure of the refrigerant discharged from the compressor 2 is detected by a discharge pressure sensor attached to the discharge tube of the compressor. The steady state in the pressure of the refrigerant discharged from the compressor 2 is, for example, a state in which a difference between a present value and a previous value of the pressure of the refrigerant discharged from the compressor 2 falls within a predetermined difference. For example, the previous value is the pressure of the refrigerant discharged from the compressor 2, which is acquired one second before the present value, and the predetermined difference is 0.1 MPa.

Alternatively, the steady state in the pressure of the refrigerant discharged from the compressor 2 may be a state in which a difference between a present value and a previous value of a saturation temperature of the refrigerant discharged from the compressor 2 falls within a predetermined difference. The saturation temperature of the refrigerant discharged from the compressor 2 will be hereinafter referred to as a "discharge saturation temperature". For example, the previous value is a discharge saturation temperature in the compressor 2, which is acquired one second before the present value, and the predetermined difference is 0.1°C.

Alternatively, the steady state in the pressure of the refrigerant discharged from the compressor 2 may be a state in which a difference between a "moving average value of the pressure of the refrigerant discharged from the compressor 2 within a first period of time" and a "moving average value of the pressure of the refrigerant discharged from the compressor 2 within a second period of time" falls within a predetermined difference. The second period of time is shorter than the first period of time. For example, the moving average value within the first period of time is a moving average value within three minutes, the moving average value within the second period of time is a moving average value within ten seconds, and the predetermined difference is 1°C.

### (2-1-2-3) Steady State in Pressure of Refrigerant sucked into Compressor 2

The pressure of the refrigerant sucked into the compressor 2 is detected by a suction pressure sensor attached to the suction tube of the compressor. The steady state in the pressure of the refrigerant sucked into the compressor 2 may be a state in which a difference between a present value and a previous value of the saturation temperature of the refrigerant sucked into the compressor 2 falls within a predetermined difference. The saturation temperature of the refrigerant sucked into the compressor 2 will be hereinafter referred to as a "suction saturation temperature". For example, the previous value is the suction saturation temperature of the compressor 2, which is acquired one second before the present value, and the predetermined difference is 0.1°C.

Alternatively, the steady state in the pressure of the refrigerant sucked into the compressor 2 may be a state in which a difference between a "moving average value of the pressure of the refrigerant sucked into the compressor 2 within a first period of time" and a "moving average value of the pressure of the refrigerant sucked into the compressor 2 within a second period of time" falls within a predetermined difference. The second period of time is shorter than the first period of time. For example, the moving average value within the first period of time is a moving average value within three minutes, the moving average value within the second period of time is a moving average value within ten seconds, and the predetermined difference is 1°C.

### (2-1-2-4) Steady State in Temperature of Refrigerant discharged from Compressor 2

The temperature of the refrigerant discharged from the compressor 2 is detected by a temperature sensor attached around the discharge port of the compressor. The steady state in the temperature of the refrigerant discharged from the compressor 2 is, for example, a state in which a difference between a present value and a previous value of the temperature of the refrigerant discharged from the compressor 2 falls within a predetermined difference. For example, a value acquired one second before the present value is acquired is adopted as the previous value, and 0.1°C is adopted as the predetermined difference.

Alternatively, the steady state in the temperature of the refrigerant discharged from the compressor 2 may be a state in which a difference between a "moving average value of the temperature of the refrigerant discharged from the compressor 2 within a first period of time" and a "moving average value of the temperature of the refrigerant discharged from the compressor 2 within a second period of time" falls within a predetermined difference. The second period of time is shorter than the first period of time. For example, a moving average value within three minutes is adopted as the moving average value within the first period of time, a moving average value within ten seconds is adopted as the moving average value within the second period of time, and 1°C is adopted as the predetermined difference.

### (2-1-2-5) Steady State in Temperature of Refrigerant sucked into Compressor 2

The temperature of the refrigerant sucked into the compressor 2 is detected by a temperature sensor attached around the suction port of the compressor. The steady state in the temperature of the refrigerant sucked into the compressor 2 is, for example, a state in which a difference between a present value and a previous value of the temperature of the refrigerant sucked into the compressor 2 falls within a predetermined difference. For example, the temperature of the refrigerant sucked into the compressor 2, which is acquired one second before the present value, is adopted as the previous value. In addition, 0.1°C is adopted as the predetermined difference.

Alternatively, the steady state in the temperature of the refrigerant sucked into the compressor 2 may be a state in which a difference between a "moving average value of the temperature of the refrigerant sucked into the compressor 2 within a first period of time" and a "moving average value of the temperature of the refrigerant sucked into the compressor 2 within a second period of time" falls within a predetermined difference. The second period of time is shorter than the first period of time. For example, a moving average value within three minutes is adopted as the moving average value within the first period of time, a moving average value within ten seconds is adopted as the moving average value within the second period of time, and 1°C is adopted as the predetermined difference.

### (2-1-2-6) Steady State in Voltage of Direct Current generated by Direct Current Generation Unit 211

The steady state in the voltage of the direct current generated by the direct current generation unit 211 is, for example, a state in which an absolute value of an alternating current component extracted from an instantaneous waveform of the voltage of the direct current generated by the direct current generation unit 211 is acquired, and its instantaneous value is equal to or less than a threshold value. The threshold value is set to, for example, a value acquired by acquiring an average value of the absolute values of the alternating current component extracted from the instantaneous waveform of the voltage of the direct current generated by the direct current generation unit 211 and multiplying the acquired average value by a predetermined coefficient. Although, when the voltage of the direct current is not steady, its waveform is disturbed and a feature amount is influenced, it is possible to select in here waveform data with less disturbance when the voltage of the direct current is steady, making it possible to acquire and output, from the waveform data, a feature amount making it possible to diagnose deterioration at high accuracy.

### (2-1-2-7) Steady State in Frequency Component of Number of Rotations of Torque of Compressor 2

Examples of a "frequency component of a number of rotations of torque of the compressor 2" include a mechanical angle first-order component (Unit: ampere) in an amplitude of an electric current vector. The amplitude of the electric current vector is a value represented by a square root of a sum of square values of phase currents in three phases of an input of the compressor 2.

An example of the steady state in a frequency component of a number of rotations of torque of the compressor 2 is a state in which the mechanical angle first-order component of the amplitude of the electric current vector falls within a specific range. Examples of the specific range described above include a range of the mechanical angle first-order component of the amplitude of the electric current vector in a state where no oil shortage has occurred and a range of the mechanical angle first-order component of the amplitude of the electric current vector in a state where no liquid compression has occurred.

Fig. 4 is a graph illustrating a relationship between VF and T before and after oil shortage has occurred. VF is the mechanical angle first-order component of the amplitude of the electric current vector. T is time of day. The time of day T1 is the time of day when oil shortage has occurred. Before oil shortage has occurred, a value of VF is VF1. When oil shortage has occurred, the value of VF changes to VF2. When a state in which the mechanical angle first-order component of the amplitude of the electric current vector falls within a specific range (range around VF1) is defined as a steady state, the mechanical angle first-order component of the amplitude of the electric current vector is out of the specific range, when oil shortage has occurred, and is thus in a non-steady state.

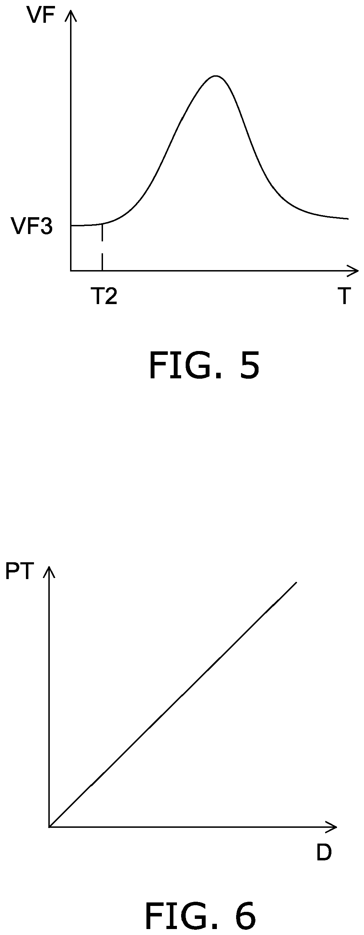

Fig. 5 is a graph illustrating a relationship between VF and T before and after liquid compression has occurred. Time of day T2 is the time of day when liquid compression has occurred. The value of VF is VF3 before liquid compression has occurred. When liquid compression has occurred, the value of VF changes. When a state in which the mechanical angle first-order component of the amplitude of the electric current vector falls within a specific range (range around VF3) is defined as a steady state, the mechanical angle first-order component of the amplitude of the electric current vector is out of the specific range, when liquid compression has occurred, and is thus in a non-steady state.

Therefore, when the frequency component of the number of rotations of torque of the compressor 2 is in the steady state, the first selection unit 112 is able to select waveform data when neither oil shortage nor liquid compression has occurred. Although, when oil shortage or liquid compression has occurred, a waveform is disturbed and a feature amount is influenced, it is possible to select in here waveform data with less disturbance when neither oil shortage nor liquid compression has occurred, making it possible to acquire and output, from the waveform data, a feature amount making it possible to diagnose deterioration at high accuracy.

### (2-1-3) Calculation Unit 113

The calculation unit 113 calculates a feature amount correlated with deterioration of the compressor 2 from waveform data selected by the first selection unit 112. A "function of calculating a feature amount correlated with deterioration of the compressor 2 from waveform data acquired from the compressor 2" is referred to as a calculation function. The calculation unit 113 achieves the calculation function. Examples of a method allowing the calculation unit 113 to calculate a feature amount include Fourier transform, Fourier series expansion, and Kalman filter.

The feature amount indicates a magnitude of a frequency component, which is N times or N/M times of the number of rotations of the motor 22, or a value other than the frequency component. N and M are integers. M is greater than N. Specific examples of the feature amount (magnitude of the frequency component) include an electrical angle third-order component of a phase current, the mechanical angle first-order component of the amplitude of the electric current vector, and a fractional-order frequency component of the amplitude of the electric current vector. In addition, specific examples of the feature amount (value other than the frequency component) include a zero-order component of the amplitude of the electric current vector and an effective value of a phase current. The effective value of the phase current is a square root of a value acquired by averaging values acquired by squaring instantaneous values of a phase current (value acquired by integrating values over one cycle and dividing the integrated value by the cycle). Note that the feature amount may be a magnitude of a frequency component of sound, vibration, voltage, or electric power. The feature amount is information correlated with deterioration. Examples of deterioration include insulation deterioration and wearing. The correlation between each feature amount and deterioration of the compressor 2 will now be described herein.

### (2-1-3-1) Correlation between Insulation Deterioration and Feature Amount

Fig. 6 is a graph illustrating a relationship between a degree of deterioration and the electrical angle third-order component of a phase current when the winding wires in the motor 22 have deteriorated in insulation and a short circuit has occurred. D is the degree of deterioration (A ratio of a number of short-circuited turns of the winding wires in the motor 22. Unit: percent). PT is the electrical angle third-order component of the phase current (Unit: ampere). As the degree of deterioration increases, the deterioration progresses. D and PT indicate a positive correlation. Deterioration (insulation deterioration) of the compressor 2 and the feature amount (electrical angle third-order component of the phase current) correlate with each other.

### (2-1-3-2) Correlation between Wearing and Feature Amount

When wearing has occurred in the compressor 2, the degree of deterioration of the compressor 2 increases. When wearing has occurred in the compressor 2, a waveform of compression torque changes, and a waveform of an electric current and a waveform of vibration change. For example, there is a change in two times or three times of a rotational frequency component of a waveform of vibration or there is a change in fractional harmonics. Therefore, it is possible to detect wearing in the compressor 2 from a waveform of vibration or a waveform of an electric current. A change in electric current when wearing has occurred will now be described herein as an example.

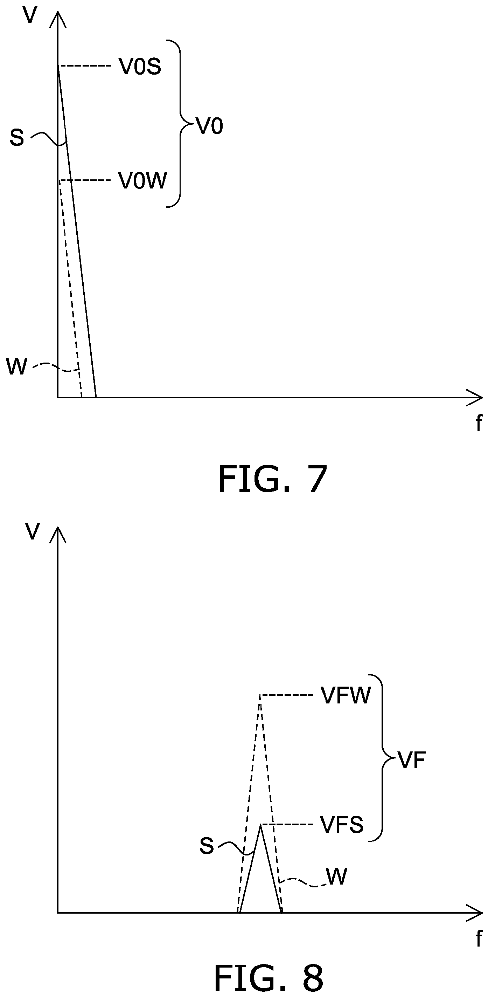

Fig. 7 is a graph illustrating V0 when wearing has occurred. V is the amplitude of the electric current vector (Unit: ampere, which will be omitted hereinafter). A frequency is represented by f (Unit: hertz, which will be omitted hereinafter). V0 is the zero-order component of the amplitude of the electric current vector. A solid line S indicates a relationship between V and f when wearing has occurred. A dotted line W indicates the relationship between V and f in a normal state. V0S that is the zero-order component of the amplitude of the electric current vector when wearing has occurred increases from V0W that is the zero-order component of the amplitude of the electric current vector in the normal state. Deterioration (wearing) of the compressor 2 and the feature amount (zero-order component of the amplitude of the electric current vector) correlate with each other.

Fig. 8 is a graph illustrating VF (mechanical angle first-order component of the amplitude of the electric current vector) when wearing has occurred. VFS that is the mechanical angle first-order component of the amplitude of the electric current vector when wearing has occurred is lower than VFW that is the mechanical angle first-order component of the amplitude of the electric current vector in the normal state. Deterioration (wearing) of the compressor 2 and the feature amount (mechanical angle first-order component of the amplitude of the electric current vector) correlate with each other.

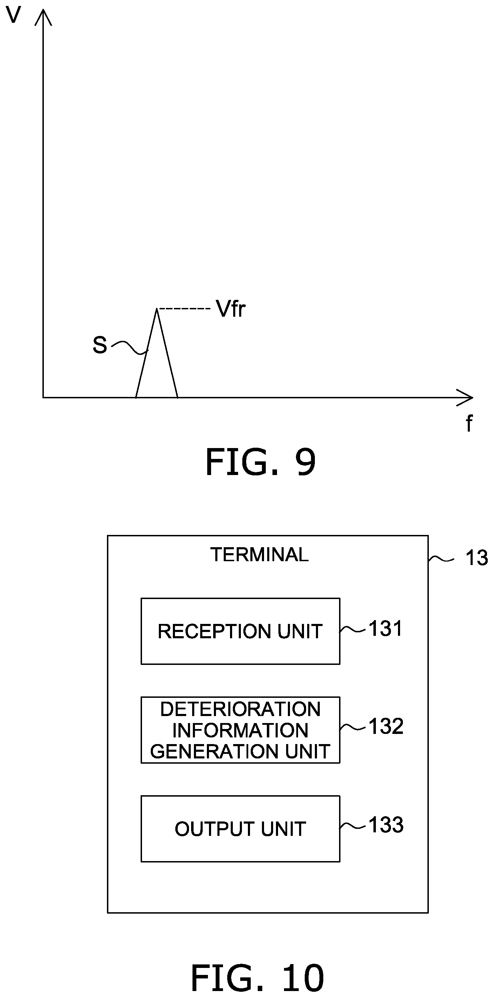

Fig. 9 is a graph illustrating Vfr when wearing has occurred. Vfr is the fractional-order frequency component of the amplitude of the electric current vector. When wearing has occurred, Vfr increases. Deterioration (wearing) of the compressor 2 and the feature amount (fractional-order frequency component of the amplitude of the electric current vector) correlate with each other.

### (2-1-4) Time Information Generation Unit 114

The time information generation unit 114 generates time information when the calculation unit 113 has calculated a feature amount. Note that the time information generation unit 114 may generate time information per certain time interval. The time information is in here information indicating cumulative operation time of the compressor 2. Note that the time information may be information indicating time of day when the calculation unit 113 has calculated a feature amount and information indicating an order of cumulation and a recording cycle at which the recording unit 115 has recorded feature amounts, for example. The time information generation unit 114 achieves a time information generation function.

### (2-1-5) Recording Unit 115

The recording unit 115 associates, with each other, a feature amount calculated by the calculation unit 113, time information generated by the time information generation unit 114, and compressor individual information stored in the storage device 12. Then, the recording unit 115 records, in the storage device 12, the feature amount, the time information, and the compressor individual information, which have been associated with each other.

Examples of the compressor individual information include identification information that is unique to the compressor 2 and information indicating a machine type and a machine number of a machine body on which the compressor 2 is mounted. The compressor individual information is stored in the storage device 12 in advance.

The recording unit 115 records, in the storage device 12, a feature amount associated with time information on an hourly basis. Note that the recording unit 115 may record the feature amount associated with time information in the storage device 12 for each recording cycle set in advance.

### (2-2) Terminal 13

The detailed configuration of the terminal 13 will now be described herein. Fig. 10 is a configuration diagram of the terminal 13. Fig. 10 illustrates various functions achieved by the control computation device. The terminal 13 includes a reception unit 131, a deterioration information generation unit 132, and an output unit 133.

### (2-2-1) Reception Unit 131

The reception unit 131 receives an output instruction that the user of the terminal 13 has inputted. The output instruction is an instruction for outputting deterioration information. The deterioration information is information in which a feature amount, time information, actual service information, and compressor individual information are associated with each other. It is also possible that the deterioration information that includes a feature amount correlated with deterioration is referred to as information correlated with deterioration.

The actual service information is information in which information related to a timing of trouble in the compressor 2, such as a history of error codes and a history of maintenance implementations, property information, and compressor individual information are associated with each other. Examples of the property information include information indicating a name of a property, a property ID, an address of the property, a user name, and a mail address. The actual service information is, for example, recorded in an external storage device (not illustrated) by the service engineer, for example, when the service engineer has performed maintenance (service) on the compressor 2.

Note that the reception unit 131 may receive an output instruction from an external component that transmits the output instruction to the reception unit 131 when a feature amount exceeds a predetermined value. An example of the predetermined value is a value that is set in advance by the service engineer.

### (2-2-2) Deterioration Information Generation Unit 132

When the reception unit 131 has received an output instruction, the deterioration information generation unit 132 generates deterioration information. The deterioration information generation unit 132 achieves a deterioration information generation function. Specific processing allowing the deterioration information generation unit 132 to generate deterioration information will now be described herein.

The deterioration information generation unit 132 acquires information in which a feature amount, time information, and compressor individual information are associated with each other from the storage device 12. The deterioration information generation unit 132 acquires, based on the compressor individual information acquired from the storage device 12, actual service information including the compressor individual information from the external storage device. The deterioration information generation unit 132 associates information acquired from the storage device 12, in which the feature amount, the time information, and the compressor individual information are associated with each other, and actual service information acquired from the external storage device with each other. Thus, the deterioration information generation unit 132 generates deterioration information.

### (2-2-3) Output Unit 133

When the reception unit 131 receives an output instruction, the output unit 133 outputs the deterioration information generated by the deterioration information generation unit 132. Examples of the output include display on a display device, notification from a speaker, printing by a printer, and delivery of a mail. The output unit 133 achieves an output function.

(2-3)
As described above, in the control device 11, the first selection unit 112 selects waveform data when an operation condition of the compressor 2 at the time when the waveform data is acquired falls within the predetermined range. Then, the calculation unit 113 calculates a feature amount correlated with deterioration of the compressor 2 from the waveform data selected by the first selection unit 112. In addition, the output unit 133 outputs deterioration information including the feature amount calculated by the calculation unit 113. In other words, it can be said that the first selection unit 112, the calculation unit 113, and the output unit 133 "output a feature amount when an operation condition of the compressor 2 at time when waveform data is acquired falls within a predetermined range". A function of acquiring a feature amount when an operation condition of the compressor 2 at time when waveform data is acquired falls within a predetermined range is referred to as a selection function. The first selection unit 112, the calculation unit 113, and the output unit 133 achieve the selection function.

### (3) Operation

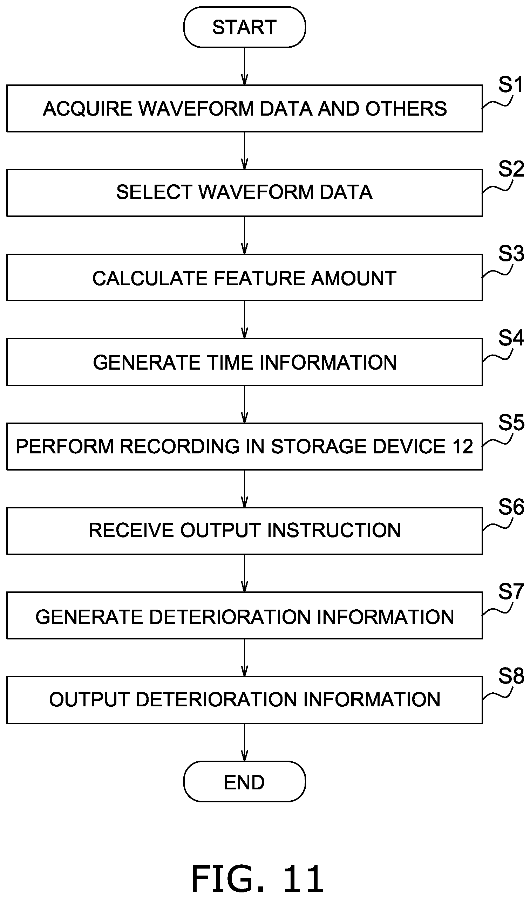

Operation of the deterioration information system 1 will now be described herein. Fig. 11 is a flowchart illustrating operation of the deterioration information system 1.

The acquisition unit 111 acquires an operation condition and waveform data from the compressor 2 (step S1). The first selection unit 112 selects the waveform data when the operation condition of the compressor 2 at the time when the waveform data is acquired falls within a predetermined range (step S2).

The calculation unit 113 calculates a feature amount correlated with deterioration of the compressors 2 from the waveform data selected at step S2 (step S3). The time information generation unit 114 generates time information (step S4).

The recording unit 115 associates, with each other, and records, in the storage device 12, the feature amount calculated at step S3, the time information generated at step S4, and compressor individual information stored in the storage device 12 (step S5). The storage device 12 stores the feature amount, the time information, and the compressor individual information, which are associated with each other.

The storage device 12 and the terminal 13 are coupled to each other through an operation of the user of the terminal 13. Thereafter, the user of the terminal 13 inputs an output instruction to the terminal 13. The reception unit 131 receives the output instruction from the user of the terminal 13 (step S6).

The deterioration information generation unit 132 generates deterioration information from information in which the feature amount, the time information, and the compressor individual information are associated with each other and actual service information acquired from the external storage device (step S7).

The output unit 133 outputs the deterioration information generated by the deterioration information generation unit 132 (step S8).

### (4) Features

(4-1)
The deterioration information system 1 is the deterioration information system 1 that calculates information correlated with deterioration of the compressor 2, and includes the control unit. The control unit has a calculation function of calculating a feature amount correlated with deterioration of the compressor 2 from waveform data acquired from the compressor 2, and a selection function of outputting a feature amount when an operation condition of the compressor 2 at the time when the waveform data is acquired falls within a predetermined range.

The control unit in the deterioration information system 1 has the calculation function of calculating a feature amount correlated with deterioration of the compressor 2, and the selection function of outputting the feature amount when an operation condition of the compressor 2 falls within a predetermined range. Therefore, the deterioration information system 1 is capable of outputting a suitable feature amount for diagnosing deterioration of the compressor 2.

Regardless of whether or not an operation condition falls within the predetermined range, a feature amount correlated with deterioration of the compressor may be calculated and outputted. The feature amount is greatly influenced not only by deterioration of the compressor but also by an operation condition. To diagnose deterioration of the compressor at high accuracy using the feature amount, it is necessary to correct an influence of the operation condition. Accuracy of a correction expression in this correction is a trade-off with an amount of data, and it is necessary to acquire a large amount of data to acquire a highly accurate correction expression. If an amount of data is small, the accuracy of the correction expression may be reduced due to a correction error. Even when a test mode (function of creating an operation condition for collecting data) is provided in a device and a feature amount calculated from waveform data acquired in the test mode is uploaded, an unnecessary operation performed in the test mode may be a hindrance for comfortability and energy conservation ability of an air conditioning apparatus, for example.

Therefore, the deterioration information system 1 outputs a suitable feature amount for diagnosing deterioration at high accuracy, compared with a case where a feature amount correlated with deterioration is outputted regardless of whether or not an operation condition falls within a predetermined range.

A person who uses the deterioration information system 1 is able to collect a plurality of feature amounts (for example, a plurality of feature amounts that are identical to each other in type) respectively from a plurality of the compressors 2. The plurality of compressors 2 are, for example, compressors for which a certain period (for example, 10 years or 12 years) has elapsed from when operation of each of the compressors 2 has been started. Feature amounts from the plurality of compressors 2 differ from each other due to various variables. Then, by taking into consideration that a feature amount correlates with deterioration, the person who uses the deterioration information system 1 is able to use an average value of a plurality of feature amounts and a standard deviation of the plurality of feature amounts to set a threshold value for the feature amount. For example, the person who uses the deterioration information system 1 is able to set, as a threshold value for a feature amount, a value acquired by adding an average value of a plurality of feature amounts and a value acquired by multiplying a standard deviation of the plurality of feature amounts by 6. The person who uses the deterioration information system 1 is able to estimate that, when a feature amount is equal to or greater than the threshold value, "there is a high possibility of a failure occurring in the compressor 2".

(4-2)
In the deterioration information system 1, waveform data is electric current waveform data indicating a waveform of an electric current in the motor 22 that the compressor 2 includes. The feature amount indicates a magnitude of a frequency component, which is N times or N/M times of the number of rotations of the motor 22. N and M are integers. M is greater than N.

It is known that, when a compressor deteriorates, a specific frequency component (such as an N/M-times frequency component) may greatly change. The deterioration information system 1 outputs a feature amount that may greatly change due to deterioration of the compressor 2. Therefore, the person who uses the deterioration information system 1 is able to more easily diagnose deterioration based on the feature amount that has been outputted.

(4-3)
In the deterioration information system 1, the compressor 2 includes the motor 22 driven by the motor drive device 21. The motor drive device 21 includes the direct current generation unit 211 and the conversion unit 212. The direct current generation unit 211 generates a voltage of a direct current in accordance with a power source voltage supplied from an external power source. The conversion unit 212 converts the voltage of the direct current, which is generated by the direct current generation unit 211, into a voltage of an alternating current through a switching operation and supplies the voltage of the alternating current to the motor 22. The operation condition is at least one of the number of rotations of the motor 22 that the compressor 2 includes, pressure of the refrigerant discharged from the compressor 2, pressure of the refrigerant sucked into the compressor 2, a temperature of the refrigerant discharged from the compressor 2, a temperature of the refrigerant sucked into the compressor 2, a frequency component of a number of rotations of torque of the compressor 2, and the voltage of the direct current. The predetermined range is a range of the operation condition when the operation state of the compressor 2 is the steady state.

For example, when the feature amount is a frequency component of an electric current in the compressor 2, the feature amount makes it possible to accurately diagnose deterioration, but is easily influenced by inertia. When the number of rotations of the compressor 2 is influenced by inertia and greatly changes, the feature amount that is the frequency component of the electric current also greatly changes. In addition, when there is a change in pressure or temperature, a waveform of load torque changes, and the feature amount that is the frequency component of the electric current also greatly changes. Therefore, it is difficult to determine deterioration with the feature amount greatly influenced by inertia. By taking into consideration those described above, the deterioration information system 1 for which cases where the operation state is the steady state are focused on reduces an influence of inertia as much as possible, and outputs a suitable feature amount making it possible to accurately determine deterioration.

(4-4)
The deterioration information system 1 uses, as an operation condition, at least one of the number of rotations of the motor 22 that the compressor 2 includes, the pressure of the refrigerant discharged from the compressor 2, the pressure of the refrigerant sucked into the compressor 2, the temperature of the refrigerant discharged from the compressor 2, and the temperature of the refrigerant sucked into the compressor 2. The predetermined range is a range of the operation condition that is set in advance.

The deterioration information system 1 outputs a feature amount when the operation condition of the compressor 2 is within the range that is set in advance. Since it is possible to suppress a change in feature amount due to a difference in operation condition, the deterioration information system 1 outputs a feature amount making it possible to diagnose deterioration at high accuracy.

(4-5)
In the deterioration information system 1, the predetermined range is changeable from outside. Therefore, for the deterioration information system 1, it is possible to adjust later the predetermined range in accordance with an operation condition with a high occurrence rate based on pieces of data collected in a certain period. In addition, for the deterioration information system 1, it is possible to make a change to a predetermined range making it possible to easily observe deterioration, and to output a feature amount making it possible to easily observe deterioration.

(4-6)
A program is a program causing a computer in the control device 11 that calculates information correlated with deterioration of the compressor 2 to execute a calculation function and a selection function. The calculation function is a function of calculating a feature amount correlated with deterioration of the compressor 2 from waveform data acquired from the compressor 2. The selection function is a function of outputting the feature amount when an operation condition of the compressor 2 at the time when the waveform data is acquired falls within a predetermined range.

The program causes the calculation function of calculating a feature amount correlated with deterioration of the compressor 2 and the selection function of outputting the feature amount when the operation condition of the compressor 2 falls within the predetermined range to be executed. Therefore, the program allows a feature amount for diagnosing deterioration to be outputted.

(4-7)
The waveform data related to the program is electric current waveform data indicating a waveform of an electric current in the motor 22 that the compressor 2 includes. The feature amount indicates a magnitude of a frequency component, which is N times or N/m times of the number of rotations of the motor 22. N and M are integers. M is greater than N.

The program allows a feature amount that may greatly change due to deterioration of the compressor 2 to be outputted. Therefore, a person who causes the program to be executed is able to more easily diagnose deterioration based on the feature amount that has been outputted.

(4-8)
The compressor 2 includes the motor 22 driven by the motor drive device 21. The motor drive device 21 includes the direct current generation unit 211 and the conversion unit 212. The direct current generation unit 211 generates a voltage of a direct current in accordance with a power source voltage supplied from an external power source. The conversion unit 212 converts the voltage of the direct current, which is generated by the direct current generation unit 211, into a voltage of an alternating current through a switching operation and supplies the voltage of the alternating current to the motor 22. The operation condition is at least one of the number of rotations of the motor 22 that the compressor 2 includes, pressure of the refrigerant discharged from the compressor 2, pressure of the refrigerant sucked into the compressor 2, a temperature of the refrigerant discharged from the compressor 2, a temperature of the refrigerant sucked into the compressor 2, a frequency component of a number of rotations of torque of the compressor 2, and the voltage of the direct current. The predetermined range is a range of the operation condition when the operation state of the compressor 2 is the steady state.

For example, when the feature amount is a frequency component, a value of the feature amount may greatly change when the number of rotations changes due to an influence of inertia. In addition, a waveform of load torque changes due to changes in pressure and temperature, and the feature amount may greatly change. The program, for which cases where the operation state is the steady state are focused on, makes it possible to output a feature amount making it possible to determine deterioration at high accuracy.

(4-9)
The operation condition related to the program is at least one of the number of rotations of the motor 22 that the compressor 2 includes, the pressure of the refrigerant discharged from the compressor 2, the pressure of the refrigerant sucked into the compressor 2, the temperature of the refrigerant discharged from the compressor 2, and the temperature of the refrigerant sucked into the compressor 2. The predetermined range is a range of the operation condition that is set in advance.

The program allows a feature amount when an operation condition of the compressor 2 falls within the range that is set in advance to be outputted. Since it is possible to suppress a change in feature amount due to a difference in the operation condition, the program allows the feature amount making it possible to diagnose deterioration at high accuracy to be outputted.

(4-10)
The predetermined range related to the program is changeable from outside. Therefore, for the program, it is possible to make an adjustment later in accordance with an operation condition with a high occurrence rate based on pieces of data collected in a certain period. In addition, for the program, it is possible to make a change to a predetermined range making it possible to easily observe deterioration, making it possible to output a feature amount making it possible to more easily observe deterioration.

(4-11)
Problems in conventional technologies related to the deterioration information system 1 and the program according to the present embodiment will now be described herein in a different way from the above description.

Conventionally, it is known that, as pressure of a refrigerant sucked from a compressor changes, an effective value of an electric current in a motor changes. By utilizing this phenomenon, it is conceivable to monitor a steady state in the effective value of the electric current in the motor instead of utilizing a steady state in the pressure of the refrigerant sucked from the compressor. However, a change in effective value of the electric current in the motor is small, compared with a change in frequency component of the electric current, which is a feature amount generated due to a change in pressure of the refrigerant sucked from the compressor. As an example, a case where a feature amount is a frequency component of the number of rotations of a motor of an amplitude of an electric current vector is considered. When wearing has occurred in the compressor, the frequency component of the number of rotations of the motor of the amplitude of the electric current vector decreases by approximately 20%, compared with that in a normal state. Under conditions that a discharge saturation temperature is 45°C, the number of rotations is 70 rps, and R410A is used as the refrigerant, and when the suction saturation temperature changes from 5°C to 10°C, a magnitude of a change in frequency component of the number of rotations of the motor of the amplitude of the electric current vector changes by 19%. This change is a change at a level identical to a level of a change along with wearing. On the other hand, a change in effective value of the electric current of the motor at this time is approximately 0.5%, and it is difficult to detect the change. As described above, it is not possible to output a suitable feature amount for diagnosing deterioration of a compressor with the method of selecting a frequency component of an electric current when an effective value of the electric current of the motor is in the steady state.

The same applies to the pressure of the refrigerant discharged from the compressor, and it is not possible to output a suitable feature amount for diagnosing deterioration of the compressor with the method of selecting the frequency component of the electric current when the effective value of the electric current of the motor is in the steady state.

In addition, as the number of rotations of the motor changes, the effective value of the electric current of the motor changes. By utilizing this phenomenon, it is conceivable to monitor the steady state in the effective value of the electric current of the motor instead of utilizing the steady state in the number of rotations of the motor. However, a change in effective value of the electric current of the motor is small, compared with a change in frequency component of the electric current, which is a feature amount generated due to a change in number of rotations of the motor. As an example, a case where a feature amount is a frequency component of the number of rotations of a motor of an amplitude of an electric current vector is considered. When wearing has occurred in the compressor, the frequency component of the number of rotations of the motor of the amplitude of the electric current vector decreases by approximately 20%, compared with that in the normal state. Under conditions that a discharge saturation temperature is 45°C, a suction saturation temperature is 5°C, and R410A is used as the refrigerant, and when the number of rotations of the motor changes from 45 rps to 49 rps, a magnitude of a change in frequency component of the number of rotations of the motor of the amplitude of the electric current vector is approximately 29%, which is greater than a magnitude of a change, which is equal to or greater than a change due to wearing of the compressor. On the other hand, a change in effective value of the electric current of the motor at this time is approximately 0.4%, and it is difficult to detect the change. As described above, it is not possible to output a suitable feature amount for diagnosing deterioration of a compressor with the method of selecting a frequency component of an electric current when an effective value of the electric current of the motor is in the steady state.

### (5) Modification Examples

### (5-1) Modification Example 1A

### (5-1-1) Configuration

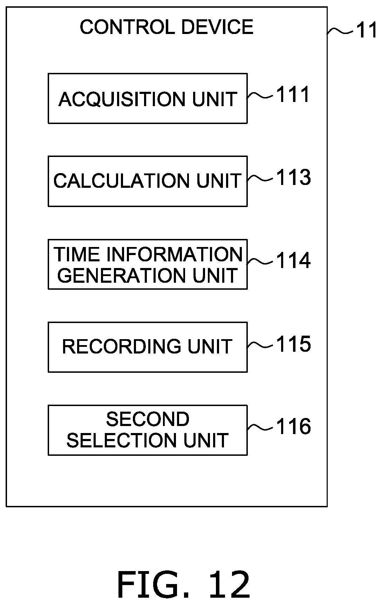

The control device 11 may include a second selection unit 116 instead of the first selection unit 112. Fig. 12 is a configuration diagram of the control device 11, according to Modification Example 1A.

The calculation unit 113 calculates feature amounts correlated with deterioration of the compressor 2 from waveform data acquired by the acquisition unit 111. The second selection unit 116 selects, from among the feature amounts calculated by the calculation unit 113, the feature amount when an operation condition of the compressor 2 at the time when the waveform data is acquired falls within a predetermined range. The recording unit 115 associates, with each other, and records, in the storage device 12, the feature amount selected by the second selection unit 116, time information generated by the time information generation unit 114, and compressor individual information stored in the storage device 12. In the case of Modification Example 1A, the second selection unit 116 and the output unit 133 achieve the selection function.

### (5-1-2) Operation

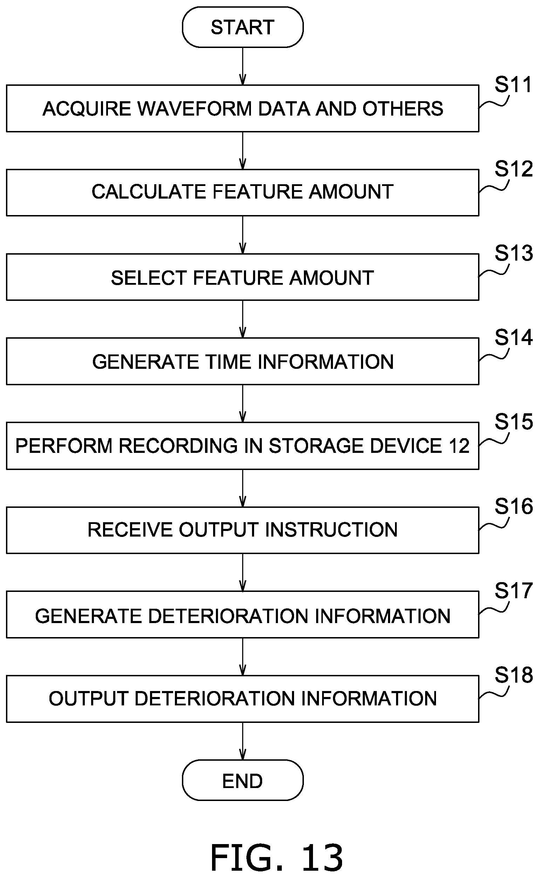

Operation of the deterioration information system 1, according to Modification Example 1A, will now be described herein. Fig. 13 is a flowchart illustrating operation of the deterioration information system 1, according to Modification Example 1A.

The acquisition unit 111 acquires an operation condition and waveform data from the compressor 2 (step S11).

The calculation unit 113 calculates feature amounts correlated with deterioration of the compressors 2 from the waveform data acquired at step S11 (step S12).

The second selection unit 116 selects, from among the feature amounts calculated at step S12, the feature amount when the operation condition of the compressor 2 at the time when the waveform data is acquired falls within a predetermined range (step S13). The time information generation unit 114 generates time information (step S14).

The recording unit 115 associates, with each other, and records, in the storage device 12, the feature amount selected at step S13, the time information generated at step S14, and compressor individual information stored in the storage device 12 (step S15). The storage device 12 stores the feature amount, the time information, and the compressor individual information, which are associated with each other.

The storage device 12 and the terminal 13 are coupled to each other in a wired or wireless manner through an operation of the user of the terminal 13. Thereafter, the user of the terminal 13 inputs an output instruction to the terminal 13. The reception unit 131 receives the output instruction from the user of the terminal 13 (step S16).

The deterioration information generation unit 132 generates deterioration information from information in which the feature amount, the time information, and the compressor individual information are associated with each other and actual service information acquired from the external storage device (step S17).

The output unit 133 outputs the deterioration information generated by the deterioration information generation unit 132 (step S18).

### (5-2) Modification Example 1B

### (5-2-1) Configuration

The terminal 13 may include a third selection unit 134 instead of the first selection unit 112 that the control device 11 includes.

### (5-2-1-1) Control Device 11

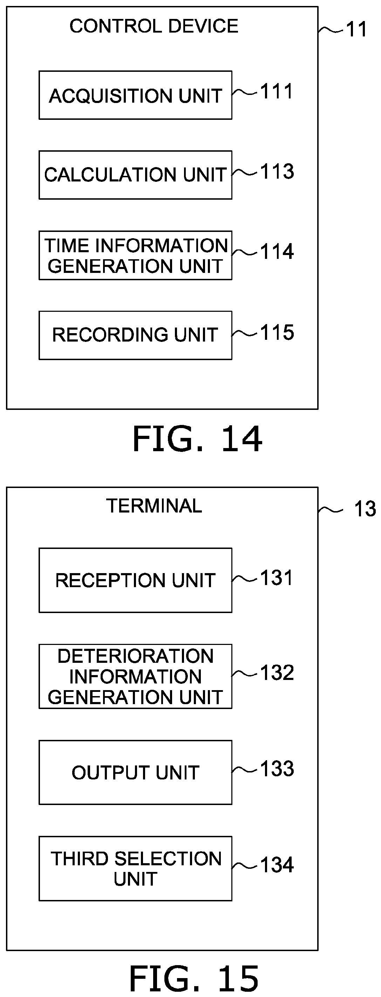

Fig. 14 is a configuration diagram of the control device 11, according to Modification Example 1B. The calculation unit 113 calculates a feature amount correlated with deterioration of the compressor 2 from waveform data acquired by the acquisition unit 111. The recording unit 115 associates, with each other, and records, in the storage device 12, an operation condition of the compressor 2 at the time when the waveform data is acquired, the feature amount calculated by the calculation unit 113, time information generated by the time information generation unit 114, and compressor individual information stored in the storage device 12.

### (5-2-1-2) Terminal 13

Fig. 15 is a configuration diagram of the terminal 13, according to Modification Example 1B. When the reception unit 131 receives an output instruction, the third selection unit 134 selects, from information stored in the storage device 12, information in which a feature amount when an operation condition of the compressor 2 at time when waveform data is acquired falls within a predetermined range, time information, and compressor individual information are associated with each other. The deterioration information generation unit 132 generates deterioration information from information in which the feature amount selected by the third selection unit 134, the time information, and the compressor individual information are associated with each other and actual service information acquired from the external storage device. In the case of Modification Example 1B, the output unit 133 and the third selection unit 134 achieve the selection function.

### (5-2-2) Operation

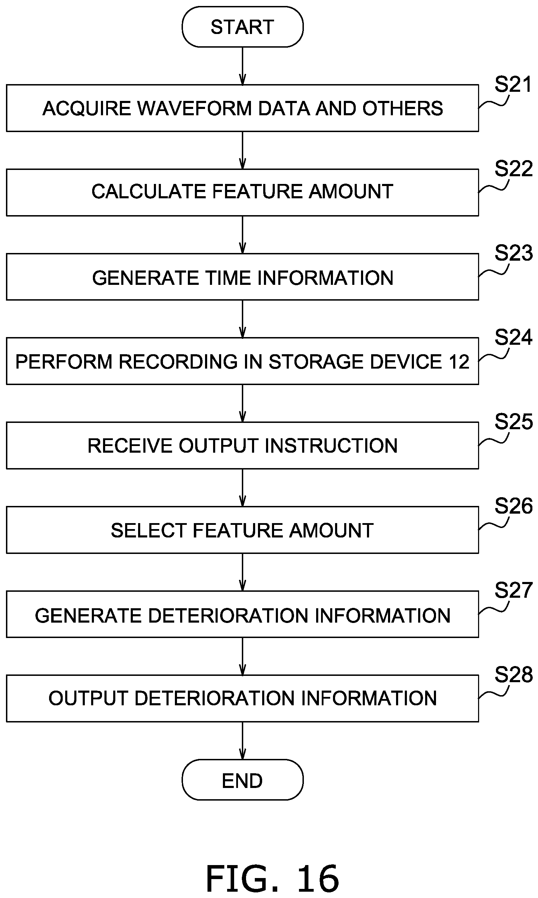

Operation of the deterioration information system 1, according to Modification Example 1B, will now be described herein. Fig. 16 is a flowchart illustrating operation of the deterioration information system 1, according to Modification Example 1B.

The acquisition unit 111 acquires an operation condition and waveform data from the compressor 2 (step S21).

The calculation unit 113 calculates a feature amount correlated with deterioration of the compressors 2 from the waveform data acquired at step S21 (step S22). The time information generation unit 114 generates time information (step S23).

The recording unit 115 associates, with each other, and records, in the storage device 12, the operation condition of the compressor 2 when the waveform data is acquired at step S21, the feature amount calculated at step S22, the time information generated at step S23, and compressor individual information stored in the storage device 12 (step S24).

The storage device 12 and the terminal 13 are coupled to each other in a wired or wireless manner through an operation of the user of the terminal 13. Thereafter, the user of the terminal 13 inputs an output instruction to the terminal 13. The reception unit 131 receives the output instruction from the user of the terminal 13 (step S25).

The third selection unit 134 selects, from information stored in the storage device 12, information in which the feature amount when the operation condition of the compressor 2 at the time when the waveform data is acquired falls within the predetermined range, the time information, and the compressor individual information are associated with each other (step S26).

The deterioration information generation unit 132 generates deterioration information from the information in which the feature amount selected by the third selection unit 134, the time information, and the compressor individual information are associated with each other and actual service information acquired from the external storage device (step S27).

The output unit 133 outputs the deterioration information generated at step S27 (step S28).

### (5-3) Modification Example 1C

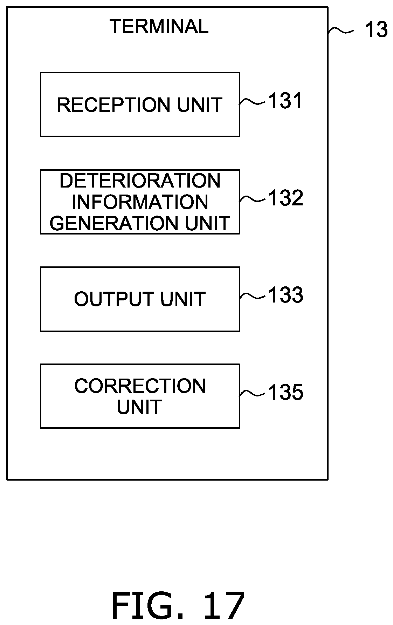

The terminal 13 may further include a correction unit 135. Fig. 17 is a configuration diagram of the terminal 13, according to Modification Example 1C.

When the reception unit 131 receives an output instruction, the correction unit 135 acquires a representative value of a feature amount in information in which a feature amount, time information, and compressor individual information, which are stored in the storage device 12, are associated with each other. Examples of the representative value include an average value of feature amounts and a median value of feature amounts in a predetermined time. For example, an average value of feature amounts in 24 hours is adopted as a representative value.

Note that, when a representative value of a feature amount is to be acquired, the correction unit 135 calculates a correction factor for a feature amount. For example, when an operation condition at time when waveform data stored in the storage device 12 is acquired is substituted into an approximate expression for acquiring a feature amount from an operation condition, it is possible to acquire a feature amount for correction. By dividing a feature amount stored in the storage device by the feature amount for correction, it is possible to correct a difference in the operation condition. As to the approximate expression, the narrower the approximation range is, the higher the accuracy is, even in a case of simple approximation such as linear approximation. Therefore, it is possible to suppress in here a variation in feature amount due to a deviation in operation condition, compared with a case where no feature amount is selected.

The correction unit 135 associates, with each other again, and transmits, to the deterioration information generation unit 132, the acquired representative value, the time information, and the compressor individual information.

The deterioration information generation unit 132 generates deterioration information from information in which the representative value transmitted from the correction unit 135, the time information, and the compressor individual information are associated with each other and actual service information acquired from the external storage device.

The deterioration information system 1 outputs the representative value of the feature amount, in which an influence of a variation in feature amount due to a deviation in operation condition is suppressed and which makes it possible to determine deterioration of the compressor 2 at high accuracy.

### (5-4) Modification Example 1D

The control device 11 and the storage device 12 may be coupled to the compressor 2 in a property in which the control device 11 and the storage device 12 are installed, and may not be coupled to a network outside the property. In this case, a feature amount is outputted by a service engineer who has arrived at the property.

### (5-5) Modification Example 1E

The control device 11 and the storage device 12 may be installed outside a refrigeration cycle device in which the compressor 2 is installed or may be installed inside the refrigeration cycle device. For example, when the compressor 2 is installed on a heat source unit of an air conditioning apparatus or a heat source unit of a hot water supply system, a microcomputer or an EEPROM in a control box installed in the heat source unit may be used to serve as both the control device 11 and the storage device 12.

### <Second Embodiment>

### (1) Configuration

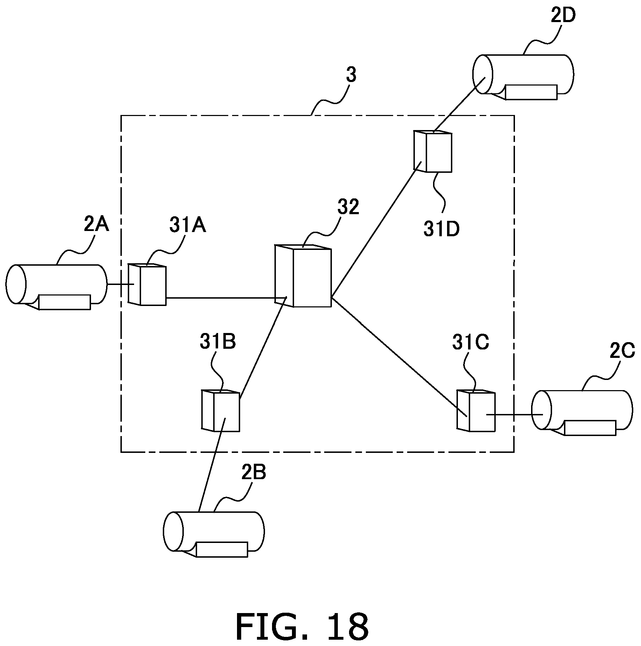

A configuration of a deterioration information system 3 according to a second embodiment will now be described herein. Fig. 18 is a schematic configuration diagram illustrating the deterioration information system 3. The deterioration information system 3 does not include the terminal 13, but includes a plurality of control devices 31 (31A to 31D) and a server 32.

The control devices 31 and the server 32 configure a control unit. Note that a number of the control devices 31 included in the deterioration information system 3 is not limited to the number illustrated in Fig. 18.

### (1-1) Control Device 31

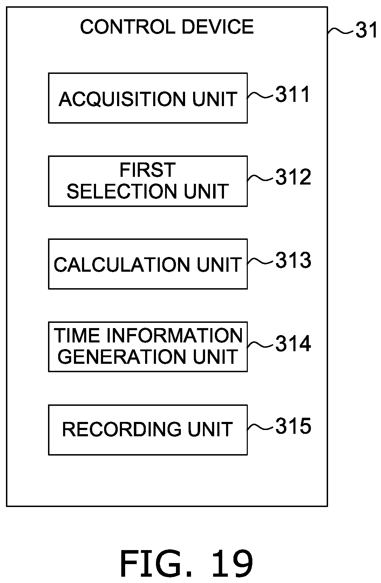

Fig. 19 is a configuration diagram of each of the control devices 31. Each control device 31 includes an acquisition unit 311, a first selection unit 312, a calculation unit 313, a time information generation unit 314, and a recording unit 315. Each control device 31 is coupled to the server 32 in a wired or wireless manner. Each control device 31 is coupled to each of the compressors 2 (2A to 2D) in a wired or wireless manner. The acquisition unit 311 is identical or similar to the acquisition unit 111. The first selection unit 312 is identical or similar to the first selection unit 112. The calculation unit 313 is identical or similar to the calculation unit 113. The time information generation unit 314 is identical or similar to the time information generation unit 114.

The recording unit 315 records, in the server 32, per hour, information in which a feature amount selected by the first selection unit 312, time information generated by the time information generation unit 314, and compressor individual information are associated with each other.

### (1-2) Server 32

The server 32 stores the information in which the feature amount, the time information, and the compressor individual information are associated with each other. The information stored in the server 32 is information that the recording unit 315 in each control device 31 records. In other words, the server 32 is a storage device that stores feature amounts of the plurality of compressors 2. The server 32 achieves a storage function.

The server 32 achieves functions identical or similar to those of the reception unit 131, the deterioration information generation unit 132, and the output unit 133. The first selection unit 312, the calculation unit 313, and the server 32 achieve the selection function.

### (1-3) Hardware Configuration

Each control device 31 and the server 32 are achieved by using a computer. Each control device 31 and the server 32 each include a control computation device and a storage device. As the control computation device, it is possible to use a processor such as a CPU or a GPU. The control computation device reads a program stored in the storage device and performs predetermined image processing and computation processing in accordance with the program. Furthermore, the control computation device is capable of writing a result of computation in the storage device and of reading information stored in the storage device in accordance with the program.

### (2) Operation

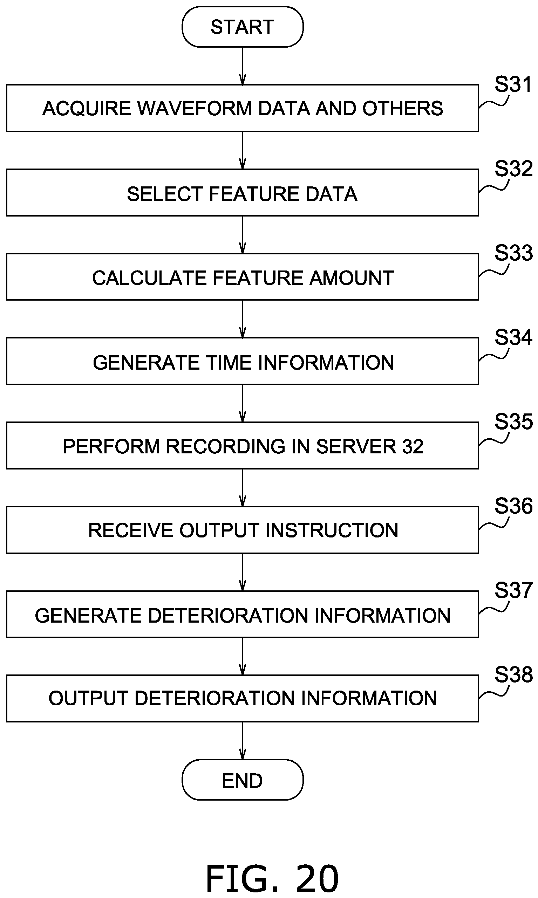

Operation of the deterioration information system 3 will now be described herein. Fig. 20 is a flowchart illustrating operation of the deterioration information system 3.

The acquisition unit 311 in each control device 31 acquires an operation condition and waveform data from the compressor 2 (step S31). The first selection unit 312 in each control device 31 selects the waveform data when an operation condition of the compressor 2 at the time when the waveform data is acquired falls within a predetermined range (step S32).

The calculation unit 313 in each control device 31 calculates a feature amount correlated with deterioration of each of the compressors 2 from the waveform data selected at step S32 (step S33). The time information generation unit 314 in each control device 31 generates time information (step S34).

The recording unit 315 in each control device 31 associates, with each other, and records, in the server 32, the feature amount calculated at step S33, the time information generated at step S34, and compressor individual information (step S35). The feature amount, the time information, and the compressor individual information are associated with each other and stored in the server 32.

The user of the server 32 inputs an output instruction to the server 32. The server 32 receives the output instruction from the user (step S36).

The deterioration information generation unit 132 generates deterioration information from information in which the feature amount, the time information, and the compressor individual information are associated with each other and actual service information acquired from the external storage device (step S37).

The server 32 outputs the deterioration information generated at step S37 for one or more of the compressors 2, which the user requests (step S38).

### (3) Features

(3-1)
The deterioration information system 3 further includes a storage device that stores feature amounts of the plurality of compressors 2.

Firstly, one merit of collecting and storing the feature amounts of the plurality of compressors 2 in the server 32 is that diagnosis for deterioration of the compressor 2 becomes easy. Collecting pieces of information related to a large number of the compressors 2 in the server 32 makes it possible to compare the pieces of information with one piece of information related to the compressor 2 that is a target of diagnosis for deterioration to perform diagnosis at high accuracy.

In addition, another merit is that it is possible to use a feature amount of another compressor 2 that satisfies a condition similar to that of the compressor 2 that is the target of diagnosis for deterioration to determine whether or not the feature amount of the compressor 2 that is the target of diagnosis for deterioration corresponds to deterioration. The other compressor 2 that satisfies the similar condition is, for example, another compressor 2 with identical operation years. Compared with the feature amounts of many other compressors 2 with the identical operation years, it is possible to diagnose that, when the feature amount of the compressor 2 that is the target of diagnosis for deterioration is deviated, there is a high possibility that the compressor 2 has been deteriorated.

(3-2)
The program further causes a storage function of storing a plurality of feature amounts of the plurality of compressors 2 in the storage device to be executed. Since the feature amounts from the plurality of compressors 2 are outputted, the program is used for diagnosing deterioration at higher accuracy.

### (4) Modification Example 2A

### (4-1) Configuration

### (4-1-1) Control Device

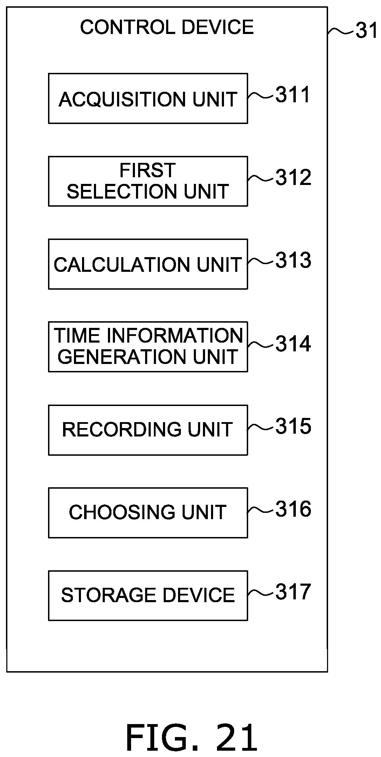

Each control device 31 may further include a choosing unit 316 and a storage device 317. Fig. 21 is a configuration diagram of the control device 31, according to Modification Example 2A.

The first selection unit 312 has a first selection function, and selects, per second, waveform data when an operation condition of the compressor 2 at the time when the waveform data is acquired falls within a predetermined range.

The recording unit 315 associates, with each other, and records, in the storage device 317, an operation condition acquired by the acquisition unit 111, a feature amount calculated by the calculation unit 313, and time information generated by the time information generation unit 314. In addition, the recording unit 315 associates, with each other, and records, in the server 32, the feature amount and the time information in information in which an operation condition, the feature amount, and the time information are associated with each other, which is selected by the choosing unit 316 described later.

The choosing unit 316 has a second selection function, and selects, per hour, information in which an operation condition including an operation condition closest to an operation condition that is set in advance, a feature amount, and time information are associated with each other in information in which operation conditions, feature amounts, and pieces of time information, which are associated with each other and recorded in the storage device 317 within an immediately previous last hour. An "operation condition closest to an operation condition that is set in advance" refers to an operation condition having a smallest difference from the operation condition that is set in advance.

Note that, instead of selecting information per hour, the choosing unit 316 may adopt a selection method of performing overwriting in feature amount each time a feature amount closer to a specified operation condition is acquired, outputting the feature amount per hour, and performing resetting in feature amount.

The storage device 317 stores information in which an operation condition, a feature amount, time information, and compressor individual information are associated with each other. Examples of the storage device 317 include an HDD and an SSD.

### (4-1-2) Server 32

The server 32 stores information in which a feature amount, time information, and compressor individual information are associated with each other. The information stored in the server 32 is information that the recording unit 315 in each control device 31 records. In other words, the feature amount stored in the server 32 is the feature amount selected based on an operation condition of the compressor 2 at time when waveform data used for performing calculation by the calculation unit 313 is acquired.

### (4-2) Operation

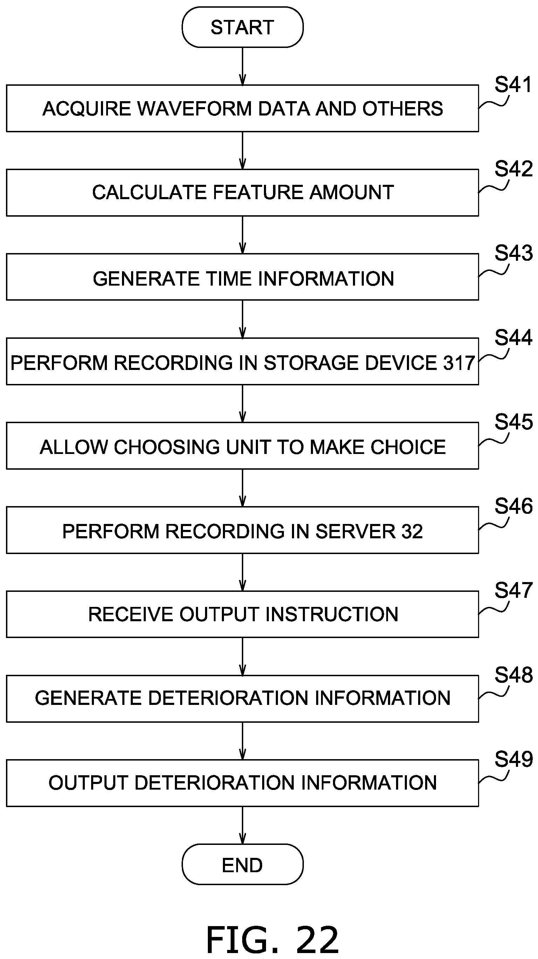

Operation of the deterioration information system 3, according to Modification Example 2A, will now be described herein. Fig. 22 is a flowchart illustrating operation of the deterioration information system 3, according to Modification Example 2A.

The acquisition unit 311 in each control device 31 acquires an operation condition and waveform data from each compressor 2 per second. (Step S41).

The calculation unit 313 in each control device 31 calculates a feature amount correlated with deterioration of each compressor 2 from the waveform data acquired at step S41 (step S42).

The time information generation unit 314 in each control device 31 generates time information (step S43).

The recording unit 315 in each control device 31 associates, with each other, and records, in the storage device 317, the operation condition acquired at step S41, the feature amount calculated at step S42, and the time information generated at step S43 (step S44).

The choosing unit 316 causes the second selection function to choose (select), per hour, information in which an operation condition including an operation condition closest to an operation condition that is set in advance, a feature amount, time information, and compressor individual information are associated with each other in information in which operation conditions, feature amounts, time information, and compressor individual information are associated with each other, which has been recorded in the storage device 317 within an immediately previous last hour (step S45).

The recording unit 315 associates, with each other, and records, in the server 32, the feature amount, the time information, and the compressor individual information in the information selected by the choosing unit 316. (Step S46).

The user of the server 32 inputs an output instruction to the server 32. The server 32 receives the output instruction from the user of the server 32 (step S47).

The server 32 generates deterioration information from the information in which the feature amount, the time information, and the compressor individual information are associated with each other, which is stored in the server 32, and actual service information acquired from the external storage device (step S48).

The server 32 outputs the deterioration information generated at step S48 (step S49).

### (4-3) Features

(4-3-1)
In the deterioration information system 3, the storage device is the server 32 or a cloud. A feature amount stored in the storage device is a feature amount selected based on an operation condition of each of the compressors at time when waveform data used for calculation is acquired.

The selected feature amount is stored in a storage device that is the server 32 or a cloud. The feature amount stored in the storage device (uploaded to the server 32 or the cloud) is a feature amount calculated under a condition close to an operation condition of a specified device. Since selection is performed before uploading to the server 32 or the cloud is performed, the deterioration information system 3 is able to collect a feature amount making it possible to increase accuracy of diagnosis for deterioration, which is performed at upload intervals with a suppressed communication cost.

(4-3-2)
In addition, similarly, the program makes it possible to collect a feature amount making it possible to increase accuracy of diagnosis for deterioration at upload intervals with a suppressed communication cost.

### <Third Embodiment>

### (1) Configuration

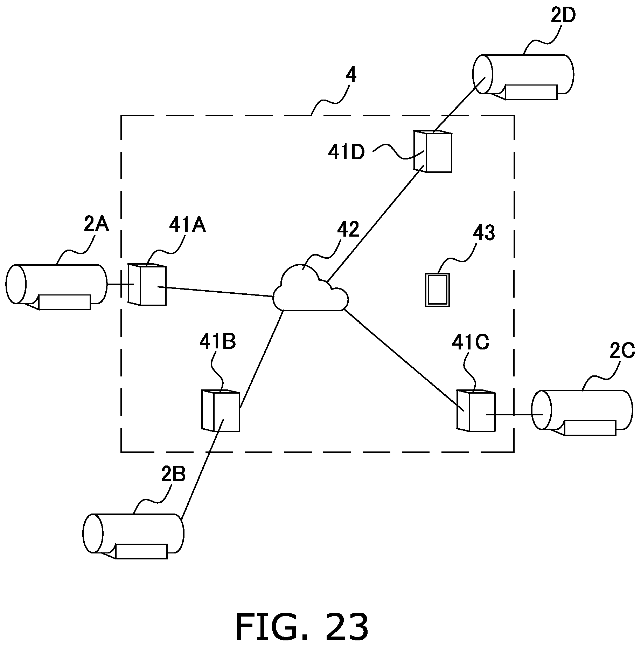

A configuration of a deterioration information system 4 according to a third embodiment will now be described herein. Fig. 23 is a schematic configuration diagram illustrating the deterioration information system 4. The deterioration information system 4 includes a plurality of control devices 41 (41A to 41D), a cloud 42, and a terminal 43.

The terminal 43 is identical or similar to the terminal 13. Note that the deterioration information system 4 may include a server instead of the cloud 42. Note that a number of the control devices 41 and a number of the terminals 43 included in the deterioration information system 3 are not limited to the numbers illustrated in Fig. 23.

### (1-1) Control Device 41

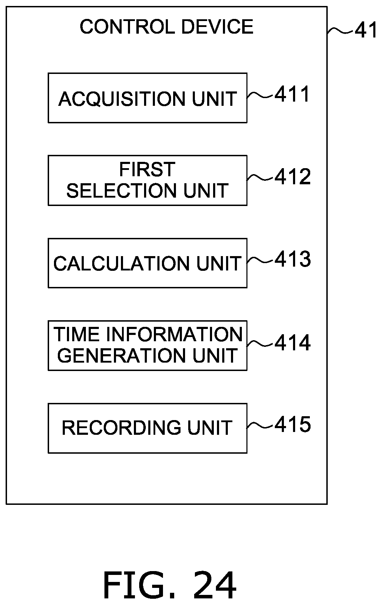

Fig. 24 is a configuration diagram of each of the control devices 41. Each control device 41 includes an acquisition unit 411, a first selection unit 412, a calculation unit 413, a time information generation unit 414, and a recording unit 415. Each control device 41 is coupled to the cloud 42 in a wired or wireless manner. Each control device 41 is coupled to each of the compressors 2 (2A to 2D) in a wired or wireless manner. The acquisition unit 411 is identical or similar to the acquisition unit 111. The first selection unit 412 is identical or similar to the first selection unit 112. The calculation unit 413 is identical or similar to the calculation unit 113. The time information generation unit 414 is identical or similar to the time information generation unit 114.

The recording unit 415 associates, with each other, and records, in the cloud 42, a feature amount calculated by the calculation unit 413, time information acquired by the acquisition unit 411, and compressor individual information.

The recording unit 415 associates, with each other, and records, in the cloud 42, per hour, a feature amount and time information. Note that the recording unit 415 may associate, with each other, and record, in the cloud 42, a feature amount, time information, and compressor individual information per recording cycle that is set in advance.

### (1-2) Cloud 42

The cloud 42 stores a feature amount, time information, and compressor individual information that the recording unit 415 in each control device 41 records.

### (1-3) Hardware Configuration

Each control device 41, the cloud 42, and the terminal 43 are each achieved by using a computer. Each control device 41, the cloud 42, and the terminal 43 each include a control computation device and a storage device. As the control computation device, it is possible to use a processor such as a CPU or a GPU. The control computation device reads a program stored in the storage device and performs predetermined image processing and computation processing in accordance with the program. Furthermore, the control computation device is capable of writing a result of computation in the storage device and of reading information stored in the storage device in accordance with the program.

### (2) Operation

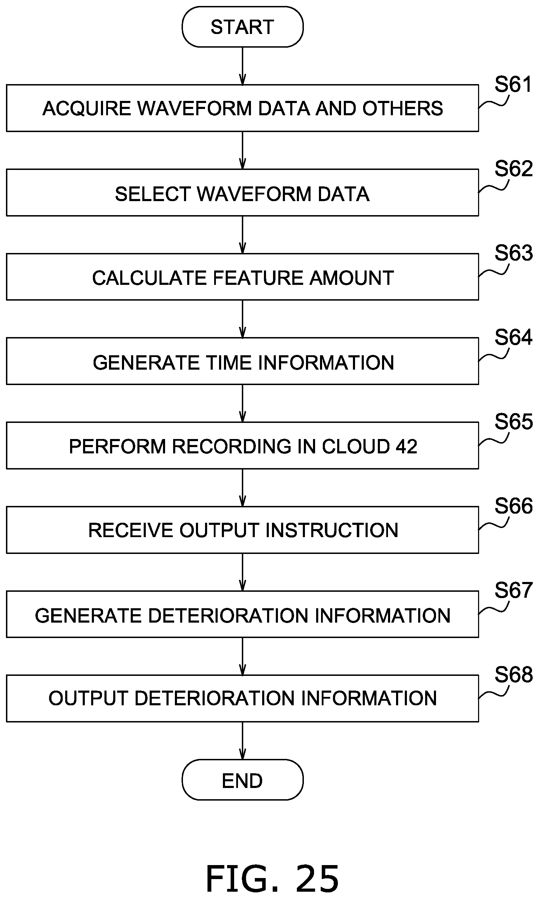

Operation of the deterioration information system 4 will now be described herein. Fig. 25 is a flowchart illustrating operation of the deterioration information system 4.

The acquisition unit 411 in each control device 41 acquires an operation condition and waveform data from each compressor 2. (Step S61).

The first selection unit 412 in each control device 41 selects waveform data when the operation condition of each compressor 2 at the time when the waveform data is acquired falls within a predetermined range (step S62).

The calculation unit 413 in each control device 41 calculates a feature amount correlated with deterioration of each compressor 2 from the waveform data selected at step S62 (step S63).

The time information generation unit 414 in each control device 41 generates time information (step S64).

The recording unit 415 in each control device 41 associates, with each other, and records, in the cloud 42, the feature amount calculated at step S63, the time information generated at step S64, and compressor individual information (step S65).

The cloud 42 and the terminal 43 are coupled to each other in a wired or wireless manner through an operation of the user of the terminal 43. Thereafter, the user of the terminal 43 inputs an output instruction to the terminal 43. The reception unit 431 receives the output instruction from the user of the device 43 (step S66).

The deterioration information generation unit 432 in the terminal 43 generates deterioration information from information in which the feature amount, the time information, and the compressor individual information are associated with each other and actual service information acquired from the external storage device (step S67).

The output unit 433 in the terminal 43 outputs the deterioration information (step S68).

While the embodiments of the present disclosure have been described above, it will be understood that various modifications in form and detail may be made therein without departing from the spirit and scope of the present disclosure as set forth in the appended claims.

### (Note 1)

A deterioration information system that calculates information correlated with deterioration of a compressor, the deterioration information system including a control unit, the control unit achieving a calculation function of calculating a feature amount correlated with deterioration of the compressor from waveform data acquired from the compressor, a selection function of selecting the feature amount when an operation condition of the compressor at the time when the waveform data is acquired falls within a predetermined range, an actual service information acquisition function of acquiring actual service information indicating whether or not there is a failure in the compressor, a deterioration information generation function of generating deterioration information by associating at least the feature amount and the actual service information with each other, and an output function of outputting the deterioration information.

A person who uses the deterioration information system according to Note 1 is able to collect deterioration information outputted from the deterioration information system. The deterioration information includes a feature amount when an operation condition falls within a predetermined range and actual service information.

After feature amounts and pieces of actual service information of many compressors are accumulated, the person who uses the deterioration information system is able to acquire distribution of the feature amounts when an abnormality has occurred in one of the compressors. Then, the person who uses the deterioration information system is able to use the distribution of the feature amounts, evaluate the feature amount of the compressor that is the target of diagnosis for deterioration, and estimate a possibility of a failure of the compressor at high accuracy. For example, a threshold value for a feature amount is set in advance based on a feature amount when a failure has occurred in the compressor (for example, a value acquired by multiplying a value of the feature amount when the failure has actually occurred by 0.8). Then, the person who uses the deterioration information system is able to estimate that, when the feature amount is equal to or greater than the threshold value, "there is a high a possibility of a failure that occurs in the compressor".

In addition, the person who uses the deterioration information system is able to grasp a feature amount in which a factor (operation condition) that may possibly lower a correlation coefficient with respect to deterioration of the feature amount is excluded.

### (Note 2)

The deterioration information system according to Note 1, in which a time information generation function of generating time information indicating a cumulative operation time of the compressor is further achieved, and the deterioration information generation function is a function of associating, with each other, at least the feature amount, the actual service information, and the time information to generate the deterioration information.

Accumulating pieces of deterioration information allows the person who uses the deterioration information system to grasp the pieces of deterioration information in a time series manner. For example, the person who uses the deterioration information system is able to predict a future time-series change in feature amount from past time-series changes in feature amount. Alternatively, using actual service information included in deterioration information makes it possible to acquire an average value of a feature amount one year before a timing when a failure has occurred in the compressor to set the acquired average value as a threshold value for a feature amount. Thus, it is possible to take a measure against a failure in advance.

### (Note 3)

The deterioration information system according to Note 1 or Note 2, in which the deterioration information generation function is a function of associating the feature amount, the time information, compressor individual information indicating identification information unique to the compressor, and the actual service information with each other to generate deterioration information.

The person who uses the deterioration information system is able to use processes described below to estimate that "there is a high possibility of a failure that occurs in the compressor". The deterioration information system allows the person who uses the deterioration information system to easily diagnose deterioration, making it possible to increase accuracy of the diagnosis for deterioration.

An aspect of deterioration of the compressor differs depending on an environment in which the compressor is disposed. In other words, depending on the environment in which the compressor is disposed, a feature amount related to the compressor may also change. The deterioration information system generates and outputs deterioration information including compressor individual information. Therefore, the person who uses the deterioration information system is able to grasp a time-series change for each individual compressor, making it possible to determine deterioration of the compressor for each aspect.

### REFERENCE SIGNS LIST

- 1: deterioration information system
- 2: compressor
- 3: deterioration information system
- 11: control device
- 21: motor drive device
- 22: motor
- 32: storage device
- 211: direct current generation unit
- 212: conversion unit

### CITATION LIST

### PATENT LITERATURE

PTL 1: Japanese Unexamined Patent Application Publication No. 2022-101344

## Claims

1. A deterioration information system (1) that calculates information correlated with deterioration of a compressor (2), the deterioration information system comprising
a control unit,
the control unit having
a calculation function of calculating a feature amount correlated with deterioration of the compressor from waveform data acquired from the compressor, and
a selection function of outputting the feature amount when an operation condition of the compressor at the time when the waveform data is acquired falls within a predetermined range.

2. The deterioration information system (3) according to claim 1, further comprising a storage device that stores a plurality of the feature amounts of a plurality of the compressors.

3. The deterioration information system according to claim 2, wherein
the storage device is a server (32) or a cloud, and
each of the feature amounts stored in the storage device is a feature amount selected based on the operation condition of each of the compressors at the time when the waveform data used for the calculation is acquired.

4. The deterioration information system according to any one of claims 1 to 3, wherein
the waveform data is electric current waveform data indicating a waveform of an electric current in a motor (22) that the compressor includes,
the feature amount indicates a magnitude of a frequency component, the magnitude being N times or N/M times of a number of rotations of the motor,
the N and the M are integers, and
the M is greater than the N.

5. The deterioration information system according to any one of claims 1 to 4, wherein
the compressor includes a motor driven by a motor drive device (21),
the motor drive device includes:
a direct current generation unit (211) that generates a voltage of a direct current in accordance with a power source voltage supplied from an external power source; and
a conversion unit (212) that converts the voltage of the direct current, the voltage being generated by the direct current generation unit, into a voltage of an alternating current through a switching operation and supplies the voltage of the alternating current to the motor,
the operation condition is at least one of
a number of rotations of the motor that the compressor includes,
pressure of a refrigerant discharged from the compressor,
pressure of the refrigerant sucked into the compressor,
a temperature of the refrigerant discharged from the compressor,
a temperature of the refrigerant sucked into the compressor,
a frequency component of a number of rotations of torque of the compressor, and
the voltage of the direct current,
and
the predetermined range is a range of the operation condition when an operation state of the compressor is a steady state.

6. The deterioration information system according to any one of claims 1 to 5, wherein
the operation condition is at least one of
a number of rotations of a motor that the compressor includes,
pressure of a refrigerant discharged from the compressor,
pressure of the refrigerant sucked into the compressor,
a temperature of the refrigerant discharged from the compressor, and
a temperature of the refrigerant sucked into the compressor,
and
the predetermined range is a range of the operation condition that is set in advance.

7. The deterioration information system according to any one of claims 1 to 6, wherein the predetermined range is changeable from outside.

8. A program causing a computer in a control device (11) that calculates information correlated with deterioration of a compressor (2) to execute
a calculation function of calculating a feature amount correlated with deterioration of the compressor from waveform data acquired from the compressor, and
a selection function of outputting the feature amount when an operation condition of the compressor at the time when the waveform data is acquired falls within a predetermined range.

9. The program according to claim 8 for further causing a storage function of storing a plurality of the feature amounts of a plurality of the compressors in a storage device to be executed.

10. The program according to claim 9, wherein
the storage device is a server (32) or a cloud, and
each of the feature amounts stored in the storage device is a feature amount selected based on the operation condition of each of the compressors at the time when the waveform data used for the calculation is acquired.

11. The program according to any one of claims 8 to 10, wherein
the waveform data is electric current waveform data indicating a waveform of an electric current in a motor (22) that the compressor includes,
the feature amount indicates a magnitude of a frequency component, the magnitude being N times or N/M times of a number of rotations of the motor,
the N and the M are integers, and
the M is greater than the N.

12. The program according to any one of claims 8 to 11, wherein
the compressor includes a motor driven by a motor drive device (21),
the motor drive device includes:
a direct current generation unit (211) that generates a voltage of a direct current in accordance with a power source voltage supplied from an external power source; and
a conversion unit (212) that converts the voltage of the direct current, the voltage being generated by the direct current generation unit, into a voltage of an alternating current through a switching operation and supplies the voltage of the alternating current to the motor,
the operation condition is at least one of
a number of rotations of the motor that the compressor includes,
pressure of a refrigerant discharged from the compressor,
pressure of the refrigerant sucked into the compressor,
a temperature of the refrigerant discharged from the compressor,
a temperature of the refrigerant sucked into the compressor,
a frequency component of a number of rotations of torque of the compressor, and
the voltage of the direct current,
and
the predetermined range is a range of the operation condition when an operation state of the compressor is a steady state.

13. The program according to any one of claims 8 to 12, wherein
the operation condition is at least one of
a number of rotations of a motor that the compressor includes,
pressure of a refrigerant discharged from the compressor,
pressure of the refrigerant sucked into the compressor,
a temperature of the refrigerant discharged from the compressor, and
a temperature of the refrigerant sucked into the compressor,
and
the predetermined range is a range of the operation condition that is set in advance.

14. The program according to any one of claims 8 to 13, wherein the predetermined range is changeable from outside.

15. The deterioration information system according to any one of claims 1 to 7, wherein the selection function includes:
a first selection function of selecting the waveform data when the operation condition of the compressor falls within a predetermined range; and
a second selection function of selecting the feature amount when the operation condition of the compressor is closest to an operation condition that is set in advance, from among a plurality of the feature amounts calculated by the calculation function from the waveform data selected by the first selection function.
